# EUROPEAN PATENT APPLICATION

(11) **EP 2 017 500 A2**
(43) Date of publication of application: **21.01.2009**
(21) Application number: 08165065.7
(22) Date of filing: 27.03.2003
(51) Int. Cl.: F16H 59/08, F16H 61/00, H05K 7/02, F16H 59/10

(54) **Control apparatus with shift position detecting device and power train provided therewith**

(30) Priority: 27.03.2002 JP 2002090011; 27.03.2002 JP 2002090012
(62) Divisional of application: 03715537.1
(71) Applicant: Aisin AW Co., Ltd., Fujii-cho Anjo-shi, Aichi 444-1192 (JP)
(72) Inventor: Murakami, Naotaka, Anjo-shi Aichi 444-1192 (JP); Ogasawara, Naoto, Anjo-shi Aichi 444-1192 (JP); Suzuki, Kenji, Anjo-shi Aichi 444-1192 (JP); Fukuta, Atsushi, Anjo-shi Aichi 444-1192 (JP); Takamatsu, Jun, Anjo-shi Aichi 444-1192 (JP)
(74) Representative: Vossius & Partner

(57) **Abstract**

A control apparatus with shift position detecting device (1) according to the present invention includes a shift position detecting device (7) for detecting a shift position that changes in accordance with an operation of a vehicle driver, an ECU (5) for controlling an A/T (2) based on a detection signal of a vehicle running state, and connectors (8) and (9) that connect to an electrical unit outside a casing (4). Further, the shift position detecting device (7), the connectors (8) and (9), and the electronic control unit (5) are electrically connected through a connecting board (14). Consequently, the shift position detecting device (7), the ECU (5), and the connectors (8) and (9) can be laid out freely.

## Description

### BACKGROUND ART

The present invention relates to a control apparatus with shift position detecting device for a power train, in which a shift position detecting device for detecting a shift position that changes in accordance with an operation of a vehicle driver, an electronic control unit (hereinafter referred to as the ECU) for controlling the power train based on a detection signal of at least a vehicle running state, and a connector portion that connects to an electrical unit outside a casing are constructed integrally. The power train mentioned here refers to an engine as a driving unit, an automatic transmission (hereinafter, also referred to as A/T) which automatically executes starting operation or gear shifting operation, a semi-automatic transmission in which the starting operation is automated while the gear shifting operation is carried out manually, a continuously variable transmission which is capable of continuously controlling a shift speed shifting ratio, an internal combustion engine and electric motor for driving a hybrid vehicle, or a motor for driving an electric vehicle.

The vehicle-mounted A/T, which is one of these power trains, is controlled by operation of a shift unit whose hydraulic control unit is operated by a vehicle driver, and an ECU for controlling the A/T based on a vehicle running condition detection signal. The ECU is mounted within a vehicle compartment or an engine room, and a neutral start switch (hereinafter referred to as the N switch) and a position sensor, which are electric devices for control, are located outside the A/T case, while sensors for engine speed and oil temperature, solenoids and other devices are in general disposed within the A/T case. In this case, the respective electric devices and the ECU are electrically connected through a wire harness, which is vehicular wiring.

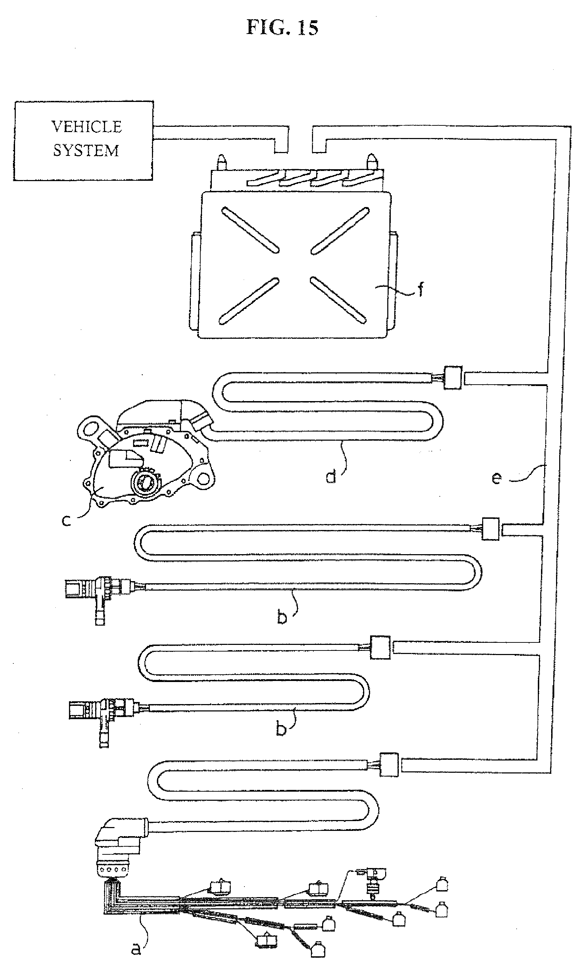

FIG. 15 is a diagram showing schematically and conceptually the electric connection between these kinds of electric devices and the ECU in a conventional A/T.

As shown in FIG. 15, wiring of the various sensors in the A/T case (not shown) is gathered together by a wire harness a, which is internal wiring of the A/T case, and guided out of the A/T case. Furthermore, wiring b for solenoids provided on a valve body within the A/T case is guided out of the A/T case individually, and wiring d of an N-switch integrated position sensor (shift position detecting sensor) c provided on an outer wall face of the A/T case is directly connected to an ECU f through a wire harness e, which is vehicular wiring.

Incidentally, when such a wiring structure is adopted, a number of wire harnesses and connectors are necessary for electric connection, so that not only the weight, but also the cost increases, and furthermore, time taken for the mounting design process and the vehicle installation process increases.

For this reason, Japanese Patent Application Laid-Open No. HEI 5-196130 proposes simplification of the wiring structure by integrating the shift position detecting sensor with the ECU. According to the wiring structure disclosed by this patent publication, complicated harness connections can be eliminated and production costs can be reduced, thereby improving mountability.

Incidentally, because the shift position detecting sensor and the ECU have different mounting positions and connector positions depending on the A/T, the layouts thereof are required to be easily and flexibly changeable to correspond to the A/T with which mounting is to take place.

However, in the integrated structure of the shift position detecting sensor and the ECU disclosed in the aforementioned patent publication, no special attention has been paid to such a requirement, and it is difficult to change the layout easily and flexibly to correspond to the A/T with which mounting is to take place. In particular, since, in the integrated structure in the aforementioned patent publication, a fixed contact of the shift position detecting sensor and a circuit board of the ECU are mounted on a single common board, it is extremely difficult to change the layout easily and flexibly to correspond to the A/T with which mounting is to take place.

Furthermore, although the ECU with the shift position detecting device in which such a shift position detecting sensor is provided integrally, is installed and fixed on an outer face of the A/T case, since the A/T is disposed within an engine room, the ECU with the shift position detecting device is also disposed within the engine room. The engine room accommodates not only an engine but also other various devices, so that installation space for the ECU to which the ECU with the shift position detecting device is fixed is limited to an extremely narrow space. Therefore, the ECU with the shift position detecting device is required to be formed as compactly as possible so as not to interfere with other the devices in the engine room. However, in the integrated structure of the shift position detecting sensor and the ECU disclosed in the aforementioned patent publication, no special consideration has been paid to such a requirement, and it cannot be said that sufficient measures have been taken for forming the ECU with the shift position detecting device as compactly as possible. In particular, it cannot be said that the ECU with the shift position detecting device has been made sufficiently compact to correspond to the aforementioned layout.

Further, because the shift position detecting sensor and the ECU have various different shapes respectively, if the shift position detecting sensor is integrated with the ECU, the integrated structure of the shift position detection sensor with the ECU is required to be constructed to be easily and flexibly changeable to correspond to these shapes to achieve as complete a compactness as possible.

However, in the integrated structure of the shift position detecting sensor and the ECU disclosed in the aforementioned patent publication, no special consideration has been paid to such a requirement, and it is difficult to change the integrated structure of the shift position detecting sensor and the ECU easily and flexibly to correspond to the respective shapes of the shift position detecting sensor and the ECU. In particular, since, in the integrated structure in the aforementioned patent publication, the fixed contact of the shift position detecting sensor and the circuit board of the ECU are mounted on a single common board, it is extremely difficult to change the integrated structure easily and flexibly to correspond to the respective shapes of the shift position detecting sensor and the ECU.

Additionally, if an apparatus in which the shift position detecting sensor is integrated with the ECU is installed for example, on an outer face of the A/T case within the engine room or within a valve body of the A/T, it is necessary to protect the ECU from severe heat within the engine room or from heat generated from a plurality of devices mounted on the control board of the ECU, to ensure accurate operation of the ECU. Thus, the control board of the ECU must use a material having a high heat dissipation capacity and heat resistance.

However, in the integrated structure disclosed in the aforementioned patent publication, it is unavoidable that the material having a high heat dissipation capacity and heat resistance must be used. In other words, since processing is not easy, it becomes necessary that a material be used that forms the fixed contact of the shift position detecting sensor and the ECU into a single common board. If such a difficult to process material is employed as the board of the aforementioned integrated structure, it is extremely difficult to change it easily and flexibly, to correspond to the respective shapes of the shift position detecting sensor and the ECU. Therefore, a problem occurs whereby dead space is generated in the casing which accommodates the shift position detecting sensor and the ECU.

Furthermore, if it is extremely difficult to correspond the shape of such a single common board to the respective shapes of the shift position detecting sensor and the ECU, it is difficult to electrically connect the shift position detecting device to the control unit flexibly and securely in accordance with the shape of the shift position detecting device or the shape of the control unit.

Further, the engine room accommodates not only an engine but also other various kinds of devices, and therefore the ECU installation space in which the ECU with the shift position detecting device is fixed is limited to a very small space. Therefore, if, as described above, the ECU with the shift position detecting device that is integrally provided with the shift position detecting sensor is disposed within the engine room, the ECU with the shift position detecting device is required to be formed as compact as possible so as not to interfere with the other devices in the engine room. However, no special attention has been paid to such a requirement in the integrated structure of the shift position detecting sensor and the ECU disclosed in the aforementioned patent publication, and therefore it cannot be said that the ECU with the shift position detecting device has been made sufficiently compact.

### DISCLOSURE OF THE INVENTION

An object of the present invention is to provide a control apparatus with shift position detecting device in which at least one of a shift position detecting device, an electronic control unit and a connector portion can be laid out freely, and which is capable of being adapted easily and flexibly depending on a power train to which it is to be mounted.

Another object of the present invention is to provide a control apparatus with shift position detecting device in which a board of a control unit thereof is capable of being adapted easily and flexibly with the shape of the shift position detecting device.

Still another object of the present invention is to provide a control apparatus with shift position detecting device and a power train provided therewith, which is capable of being adapted easily and flexibly with the shape of at least one of the shift position detecting device, the control unit and the connector portion.

Yet still another object of the present invention is to provide power trains provided with these control apparatuses with shift position detecting devices.

To achieve the aforementioned objects, the control apparatus with shift position detecting device according to the present invention is characterized by including a shift position detecting device for detecting a shift position that changes in accordance with an operation of a vehicle driver, an electronic control unit for controlling a power train based on a detection signal of at least a vehicle running state, and a connector portion that connects to an eternal electrical unit, wherein at least one of the shift position detecting device and the connector portion is connected electrically to the control unit through a connecting board.

Furthermore, the control apparatus with shift position detecting device according to the present invention is **characterized in that** the control unit has a control board in which a plurality of devices are disposed, and the shift position detecting device is connected to the control board through the connecting board.

The control apparatus with shift position detecting device according to the present invention is further **characterized in that** the control board is constituted by a board comprising material having a higher heat dissipation capacity than the connecting board.

The control apparatus with shift position detecting device according to the present invention is further **characterized in that** the control board is constituted by a board comprising material having a higher heat resistance than the connecting board.

The control apparatus with shift position detecting device according to the present invention is further **characterized in that** the connecting board is constituted by a board comprising less expensive material than the connecting board.

Moreover, the invention according to claim 6 is **characterized in that** the control board is constituted by a ceramic board.

The control apparatus with shift position detecting device according to the present invention is further characterized in that the connecting board is constituted by a board that is flexible.

The control apparatus with shift position detecting device according to the present invention is further **characterized in that** the connecting board is constituted by a glass cloth epoxy board.

The control apparatus with shift position detecting device according to the present invention is further **characterized in that** the shift position detecting device is constituted by a non-contact type shift position detecting device.

The control apparatus with shift position detecting device according to the present invention is further **characterized in that** the non-contact type shift position detecting device is provided on a manual shaft, and includes magnetic field generating means in which a generated magnetic field changes in accordance with an operation by the vehicle driver, and a sensor, the output of which changes in relation to the changing magnetic field.

The control apparatus with shift position detecting device according to the present invention is further characterized in having an output circuit portion for outputting a signal from the sensor, wherein the output circuit portion is connected to the connecting board.

The control apparatus with shift position detecting device according to the present invention is further characterized in having an overlap portion where the output circuit portion and the connecting board overlap each other on the same plane, wherein the output circuit portion and the connecting board are joined by soldering at the overlap portion.

The control apparatus with shift position detecting device according to the present invention is further **characterized in that** the shift position detecting device is a contact-type shift position detecting device which is provided on a manual shaft and includes a movable contact that moves in accordance with an operation of the vehicle driver, and a fixed contact provided on a fixing base, and detects a shift position depending on contact or non-contact between the movable contact and the fixed contact.

The control apparatus with shift position detecting device according to the present invention is further **characterized in that** the contact-type shift position detecting device has an output circuit portion for outputting a signal, and the output circuit portion is connected with the connecting board.

The control apparatus with shift position detecting device according to the present invention is further characterized in having an overlap portion where the output circuit portion and the connecting board overlap each other on the same plane, wherein the output circuit portion and the connecting board are joined by soldering at the overlap portion.

The control apparatus with shift position detecting device according to the present invention is further characterized in having an overlap portion where the control board and the connecting board overlap in a vertical direction with respect to a plane in which the control board is disposed, wherein the control board and the connecting board are joined by soldering at the overlap portion.

The control apparatus with shift position detecting device according to the present invention is further **characterized in that** the control board and the connecting board are disposed so as not to overlap in a vertical direction with respect to the plane in which the control board is disposed.

The control apparatus with shift position detecting device according to the present invention is further **characterized in that** the shift position detecting device and the control board are disposed so as not to overlap on the same plane.

The control apparatus with shift position detecting device according to the present invention is further **characterized in that** the shift position detecting device and the control board are disposed so as not to overlap in a vertical direction with respect to the plane in which the control board is disposed.

The control apparatus with shift position detecting device according to the present invention is further **characterized in that** the shift position detecting device and the control board are accommodated in a casing, and in having a plane adjusting portion for carrying out at least one of height adjustment between the shift position detecting device and the connecting board, and height adjustment between the connecting board and the control board.

The control apparatus with shift position detecting device according to the present invention is further **characterized in that** the casing has a concave and convex surface at portions in which the shift position detecting device and the control board are provided.

The control apparatus with shift position detecting device according to the present invention is further **characterized in that** the casing has a wall between the shift position detecting device and the control board.

The control apparatus with shift position detecting device according to the present invention is further **characterized in that** the wall includes a first wall which surrounds the shift position detecting device and a second wall which surrounds the control board.

The control apparatus with shift position detecting device according to the present invention is further **characterized in that** the casing includes a body portion and a cover portion, and the shift position detecting device is held by the body portion and the cover portion.

The control apparatus with shift position detecting device according to the present invention is further **characterized in that** sealing is performed between the body portion and the cover portion, and the sealing is accomplished on the same plane.

The control apparatus with shift position detecting device according to the present invention is further **characterized in that** the shift position detecting device is bonded to the casing and the first wall.

The control apparatus with shift position detecting device according to the present invention, wherein the shift position detecting device for detecting the shift position that changes in accordance with the operation of the vehicle driver and the control unit having the control board that includes the plurality of devices for controlling the power train based on a detection signal of at least a vehicle running state are accommodated in the casing, is further **characterized in that** the control board is formed of an easy to process material, and the shift position detecting device and the control board are electrically connected.

The control apparatus with shift position detecting device according to the present invention is further **characterized in that** the control board is constituted by a glass cloth epoxy board having a high heat dissipation capacity and a high heat resistance.

The control apparatus with shift position detecting device according to the present invention is further **characterized in that** the control board conforms to the shape of the shift position detecting device.

The control apparatus with shift position detecting device according to the present invention is further **characterized in that** the shift position detecting device has a circular section orthogonal to its axial direction, and the control board is formed with an external shape having a curvature that conforms to the circular section.

The control apparatus with shift position detecting device according to the present invention, wherein the shift position detecting device for detecting the shift position that changes in accordance with the operation of a shift device by the vehicle driver and the control unit having the control board that includes the plurality of devices for controlling the power train based on a detection signal of at least a vehicle running state are integrated and accommodated in the casing, is further **characterized in that** the shift position detecting device or the control board is connected electrically by a connecting board that is easy to process.

The control apparatus with shift position detecting device according to the present invention is further **characterized in that** the connecting board conforms to the shape of the shift position detecting device or the shape of the control unit.

The control apparatus with shift position detecting device according to the present invention, wherein the shift position detecting device for detecting the shift position that changes in accordance with the operation of the vehicle driver and the control unit having the control board that includes the plurality of devices for controlling the power train based on a detection signal of at least a vehicle running state are integrated and accommodated in the casing, is further **characterized in that** at least the shift position detecting device is connected to a connecting board that conforms to the shape of the shift position detecting device, or the control unit is connected to a connecting board that conforms to the shape of the control unit.

The control apparatus with shift position detecting device according to the present invention is further **characterized in that** the shift position detecting device has a circular section orthogonal to its axial direction, and the control board is formed with an external shape having a curvature that conforms to the circular section.

The control apparatus with shift position detecting device according to the present invention, where the shift position detecting device for detecting the shift position that changes in accordance with the operation of the vehicle driver and the control unit having the control board that includes the plurality of devices for controlling the power train based on a detection signal of at least a vehicle running state are integrated and accommodated in the casing, is further **characterized in that** the shift position detecting device and the control unit are connected to a connecting board, and a space within the casing other than a space in which the control board and the shift position detecting device are disposed is substantially occupied by the connecting board.

The control apparatus with shift position detecting device according to the present invention is further **characterized in that** the connecting board is constituted of material that is easier to process than the control board.

The control apparatus with shift position detecting device according to the present invention is further **characterized in that** the control board and the shift position detecting device are connected through the connecting board.

The control apparatus with shift position detecting device according to the present invention is further characterized in having a connector portion which is integrated with the shift position detecting device and the control unit, and connected to an electrical unit located outside the casing, wherein the connector portion is connected to the control board through the connecting board.

The control apparatus with shift position detecting device according to the present invention is further **characterized in that** the connector portion includes a first connector portion that connects to an electrical unit within the power train and a second connector portion that connects to a vehicle system outside the power train.

The control apparatus with shift position detecting device according to the present invention is further **characterized in that** the control board is formed in a quadrangular shape, and the connecting board is formed in a shape that conforms to the quadrangular shape of the control board.

The control apparatus with shift position detecting device according to the present invention is further characterized in including a connector portion which is integrated with the shift position detecting device and the control unit, and is connected to the electrical unit outside the casing, wherein the control board and the shift position detecting device are connected through the connecting board, and the control board and the connector portion are connected through a second connecting board different from the aforementioned connecting board.

The control apparatus with shift position detecting device according to the present invention is further **characterized in tha**t the aforementioned connecting boards include a first connecting board for connecting the shift position detecting device to the control board, a second connecting board for connecting the first connector portion to the control board, and a third connecting board for connecting the second connector portion to the control board, wherein, of the first to the third connecting boards, at least two connecting boards are formed from a common single board.

The control apparatus with shift position detecting device according to the present invention is further **characterized in that** the shift position detecting device has an output portion for outputting a shift position detection signal, and the connecting board is formed in a shape corresponding to the quantity of terminals of the output portion.

The control apparatus with shift position detecting device according to the present invention is further **characterized in that** the connecting board is formed in a shape corresponding to the quantity of terminals of at least one of the first connector portion and the second connector portion.

The control apparatus with shift position detecting device according to the present invention is further **characterized in that** the control board is formed in a rectangular shape having a long side and a short side, and the shift position detecting device and the first connector portion are disposed in the vicinity of the long side while the second connector portion is disposed in the vicinity of the short side.

The control apparatus with shift position detecting device according to the present invention is further **characterized in that** a connecting portion of the first connector portion and the control unit laps a side of the shift position detecting device.

The control apparatus with shift position detecting device according to the present invention is further **characterized in that** the output portion has a projection portion that projects from the shift position detecting device, and a sectional shape of the shift position detecting device including the projection portion is an elliptical or substantially elliptical shape including a major axis and a minor axis, and the major axis and the long side of the control board are arranged so as to be parallel or substantially parallel.

The control apparatus with shift position detecting device according to the present invention, wherein the shift position detecting device for detecting the shift position that changes in accordance with the operation of the vehicle driver, and the control unit having the control board that includes the plurality of devices for controlling the power train based on a detection signal of at least a vehicle running state are integrated and accommodated in the casing, is further characterized in having a connector portion that connects to an eternal electrical unit, and that the shift position detecting device and the connector portion are arranged in parallel in the vicinity of one side of the control board.

The control apparatus with shift position detecting device according to the present invention is further **characterized in that** the control board is constituted of a quadrangular ceramic board.

The control apparatus with shift position detecting device according to the present invention is further **characterized in that** the control board is formed in a quadrangular shape and has a first connector that connects to an electrical unit inside a power train, and a second connector portion that connects to a vehicle system outside the power train, and the shift position detecting device is disposed in parallel with any one of the first connector portion and the second connector portion in the vicinity of the quadrangular shape, while the other of the first connector portion and the second connector portion is disposed in the vicinity of the other side of the quadrangular shape.

The control apparatus with shift position detecting device according to the present invention is further **characterized in that** the control board is connected to the shift position detecting device through the connecting board.

The control apparatus with shift position detecting device according to the present invention is further **characterized in that** the connecting boards include a first connecting board for connecting the shift position detecting device to the control board, a second connecting board for connecting the first connector portion to the control board and a third connecting board for connecting the second connector portion to the control board, wherein, of the first to the third connecting boards, at least two connecting boards are formed of a common single board.

The control apparatus with shift position detecting device according to the present invention is further **characterized in that** the shift position detecting device has an output portion for outputting a shift position detection signal, and is formed in a shape corresponding to the quantity of terminals of the output portion.

The control apparatus with shift position detecting device according to the present invention is further **characterized in that** the connecting board is formed in a shape corresponding to the quantity of terminals of at least one of the first connector portion and the second connector portion.

The control apparatus with shift position detecting device according to the present invention is further **characterized in that** the quadrangular shape of the control board is rectangular, and the shift position detecting device and the first connector portion are disposed in the vicinity of the long side of the rectangle while the second connector portion is disposed in the vicinity of the short side of the rectangle.

The control apparatus with shift position detecting device according to the present invention is further **characterized in that** the connecting portion of the first connector portion and the control unit laps a side of the shift position detecting device.

The control apparatus with shift position detecting device according to the present invention is further **characterized in that** the output portion has a projection portion that projects from the shift position detecting device, and a sectional shape of the shift position detecting device including the projection portion is an elliptical or substantially elliptical shape including a major axis and a minor axis, and the major axis and the long side of the control board are arranged so as to be parallel or substantially parallel.

The control apparatus with shift position detecting device according to the present invention is further **characterized in that** a connector portion that connects to an electrical unit outside the casing has a stress absorbing and alleviating portion.

Moreover, the power train according to the present invention is characterized in including any of the aforementioned control apparatuses with the shift position detecting device.

Since, in the control apparatus with shift position detecting device according to the present invention having such a structure, at least one of the shift position detecting device and the connector portion is connected to the control board through the connecting board, at least one of the shift position detecting device, the control unit and the connector portion can be laid out freely within the casing.

In particular since, in the control apparatus with shift position detecting device according to the present invention, the shift position detecting device is connected to the control board through the connecting board, connection between the shift position detecting device and the control board of the control unit can be laid out freely, thereby increasing versatility.

Moreover, since, in the control apparatus with shift position detecting device according to the present invention, the control board is constituted by a board comprising material having a high heat dissipation capacity, heat from devices mounted on the control board can be dissipated effectively.

Moreover, since, in the control apparatus with shift position detecting device according to the present invention, the control board is constituted by a board comprising material having a high heat resistance, reduction in durability caused by heat from the devices mounted on the control board can be prevented.

Moreover, since, in the control apparatus with shift position detecting device according to the present invention, the connecting board is constituted by a board comprising less expensive material, an increase in cost can be suppressed and, by using a board which enables a more accurate control for the control board in which the devices are disposed, control reliability can be secured.

Moreover, since, in the control apparatus with shift position detecting device according to the present invention, the control board is constituted by a ceramic board, heat dissipation and heat resistance are improved, thereby minimizing increases in cost.

Moreover, since, in the control apparatus with shift position detecting device according to the present invention, the connecting board is constituted by a board that is flexible, deviation (manufacturing error of a component or installation error of a component) of a component when electrically connected can be absorbed due to the flexibility of the board material, and even if, for example, the control apparatus with shift position detecting device is placed in an extremely severe thermal environment such as an engine room, and at least one of the shift position detecting device and the connector portion that connects to the connecting board expands or contracts due to the heat therein, that expansion or contraction can be absorbed effectively due to the flexibility of the board material.

Moreover, since, in the control apparatus with shift position detecting device according to the present invention, the connecting board is constituted by a glass cloth epoxy board (hereinafter also referred to as a glass epoxy board), connecting means can be formed cheaply, thereby preventing an increase in cost of the control apparatus with shift position detecting device.

Moreover, since, in the control apparatus with shift position detecting device according to the present invention, the shift position detecting device is constituted by a non-contact type shift position detecting device, it is not necessary to provide a contact for each shift position, unlike with a contact-type shift position detecting device, thereby enabling the apparatus to be constructed in a compact shape.

Moreover, since, in the control apparatus with shift position detecting device according to the present invention, the non-contact type shift position detecting device is provided on a manual shaft and includes magnetic field generating means in which a generated magnetic field changes in accordance with an operation by the vehicle driver, and a sensor whose output changes in relation to the changing magnetic field, the magnetic field of the magnetic field generating means changes in accordance with a operation of the vehicle driver so that the output of the sensor changes continuously, thereby enabling the shift position to be detected continuously.

Moreover, since, in the control apparatus with shift position detecting device according to the present invention, the output circuit portion for outputting a signal from the sensor is connected to the connecting board, the sensor and the connecting board can be connected together easily.

Moreover, since, in the control apparatus with shift position detecting device according to the present invention, the output circuit portion and the connecting board are joined by soldering at the overlap portion, where the output circuit portion and the connecting board are located on the same plane, the sensor and connecting board can be connected to each other easily and securely, and at a lower cost than in the case of wire bonding or the like whose bonding surface state needs to be controlled strictly.

Moreover, since, in the control apparatus with shift position detecting device according to the present invention, the shift position detecting device is a contact-type shift position detecting device, the control apparatus with shift position detecting device can be achieved using a contact-type shift position detecting device generally used in a conventional power train, and consequently the control apparatus with shift position detecting device can be formed at a low price.

Moreover, since, in the control apparatus with shift position detecting device according to the present invention, the output circuit portion of the shift position detecting device is connected with the connecting board, the shift position detecting device and the connecting board can be connected to each other easily.

Moreover, since, in the control apparatus with shift position detecting device according to the present invention, the output circuit portion and the connecting board are joined by soldering at the overlap portion, the sensor and the connecting board can be connected to each other easily and securely, and at a cheaper price than in the case of wire bonding whose bonding surface state needs to be controlled strictly.

Moreover, since, in the control apparatus with shift position detecting device according to the present invention, the control board and the connecting board are joined by soldering at the overlap portion where the control board and the connecting board overlap in a vertical direction, the control board and the connecting board can be connected to each other easily and securely, and at a cheaper price than in the case of wire bonding whose bonding state condition needs to be controlled strictly.

Moreover, since, in the control apparatus with shift position detecting device according to the present invention, the control board and the connecting board are disposed so as not to overlap in a vertical direction with respect to the plane in which the control board is disposed, the connecting portion between the control board and the connecting board can be made thinner, thereby enabling the control apparatus with shift position detecting device to be formed more compact by that amount.

Moreover, since, in the control apparatus with shift position detecting device according to the present invention, the shift position detecting device and the control board are disposed so as not to overlap on the same plane, the control apparatus with shift position detecting device can be made thinner over its entirety and consequently, when the control apparatus with shift position detecting device is mounted at various kinds of positions, interference with other devices can be prevented.

Moreover, since, in the control apparatus with shift position detecting device according to the present invention, the shift position detecting device and the control board are disposed so as not to overlap in a vertical direction with respect to the plane in which the control board is disposed, the control apparatus with shift position detecting device can be made thinner over its entirety and, consequently, when the control apparatus with shift position detecting device is mounted at various kinds of positions, interference with other devices can be prevented.

Moreover, in the control apparatus with shift position detecting device according to the present invention, even if the height of the shift position detecting device is different from the height of the control board, the height thereof can be adjusted by the plane adjusting portion, so that the connection with the connecting board is facilitated by this height adjustment.

Moreover, since, in the control apparatus with shift position detecting device according to the present invention, the shift position detecting device and the control board are provided on a concave and convex surface of the casing, even if the height of the shift position detecting device is different from the height of the control board, the shift position detecting device and the control board can be arranged on the same plane by using the concave and convex surface, so that the connection with the connecting board is facilitated by this arrangement on the same plane.

Moreover, since, in the control apparatus with shift position detecting device according to the present invention, the casing has a wall between the shift position detecting device and the control board, the shift position detecting device and the control board can be disposed based on this wall, thereby improving operability. Additionally, movement of the shift position detecting device and the control board in a horizontal direction with respect to the casing can be restricted by the wall. Furthermore, since foreign material such as minute particles of dust or the like generated from the shift position detecting device are blocked by the wall, an adverse effect on the control board caused by this foreign material can be prevented.

Moreover, since, in the control apparatus with shift position detecting device according to the present invention, the shift position detecting device and the control board can be disposed based on the first and second walls, operability is improved, and horizontal movement of the shift position detecting device and the control board with respect to the casing can be restricted by the walls.

Moreover, since, in the control apparatus with shift position detecting device according to the present invention, the shift position detecting device is held by the body portion and cover portion of the casing, the shift position detecting device can be fixed to the casing even without additional provision of a member for restricting vertical movement of the shift position detecting device with respect to the casing, thereby preventing an increase in cost.

Moreover, since, in the control apparatus with shift position detecting device according to the present invention, sealing between the body portion and the cover portion is accomplished on the same plane, the sealing can be executed effectively, thereby enabling the sealing performance to be improved and the sealing to be carried out easily.

Moreover, since, in the control apparatus with shift position detecting device according to the present invention, the shift position detecting device is bonded to the casing and the first wall, the shift position detecting device can be bonded so that horizontal movement thereof with respect to the casing is restricted by the first wall, and so that vertical movement thereof with respect to the board is restricted by the casing. That is, a multiplier effect caused by bonding along two directions, the horizontal direction and the vertical direction, which are orthogonal to each other, enables the bonding strength of the shift position detecting device to be intensified.

Moreover, since, in the control apparatus with shift position detecting device according to the present invention, an easy to process material is employed for the control board of the control unit, the control board can be connected to the shift position detecting device in accordance with the shape of the shift position detecting device. Thus, regardless of the shape of the shift position detecting device, the electrical connection can be achieved flexibly and securely. Additionally, because no connecting board is employed, the quantity of components can be reduced, thereby achieving reduction in cost.

In particular, since, in the control apparatus with shift position detecting device according to the present invention, a glass cloth epoxy board having a high heat dissipation capacity and a heat resistance is employed for the control board, it is cheaper than a board made out of ceramic or the like, and reduction in cost can be achieved.

Furthermore, since, in the control apparatus with shift position detecting device according to the present invention, the shape of the control board conforms to the shape of the shift position detecting device, adaptation to the shape of the control board can be carried out flexibly regardless of the shape of the shift position detecting device, and connection between the control board and the shift position detecting device can be carried out flexibly and easily.

Moreover, since, in the control apparatus with shift position detecting device according to the present invention, the external shape of the connecting board conforms to the circular sectional shape of the shift position detecting device, dead space in the casing can be employed more effectively by the connecting board.

Moreover, since, in the control apparatus with shift position detecting device according to the present invention, a connecting board that is easy to process is connected to the shift position detecting device or the control unit, the connecting board can be connected to the shift position detecting device or the control unit in accordance with the shape of the shift position detecting device or the shape of the control unit. Therefore, electrical connection can be executed flexibly and securely regardless of the shape of the shift position detecting device or the shape of the control unit.

Moreover, since, in the control apparatus with shift position detecting device according to the present invention, at least one of the shift position detecting device and the control unit is connected through the connecting board that conforms to at least the shape of at least one of the shift position detecting device and the control unit, connection with the connecting board can be carried out flexibly and easily, regardless of the shape of at least one of the shift position detecting device and the control unit.

Moreover, since, in the control apparatus with shift position detecting device according to the present invention, a space in the casing other than a space in which the control board and the shift position detecting device are disposed is substantially occupied by the connecting board, dead space in the casing can be utilized effectively.

Moreover, since, in the control apparatus with shift position detecting device according to the present invention, the shift position detecting device or the control board is connected with the connecting board that is easier to process than the control board, regardless of the shape of each of the shift position detecting device or the control unit, by processing the shape of the connecting board so that it conforms to the shape of the shift position detecting device or the control unit, the connection with the shift position detecting device or the control unit can be carried out along these shapes more flexibly and easily.

Moreover, since, in the control apparatus with shift position detecting device according to the present invention, the control board and the shift position detecting device are connected through the connecting board, the connecting board can be connected to the shift position detecting device or the control board easily by conforming it with these shapes.

Moreover, since, in the control apparatus with shift position detecting device according to the present invention, the connector portion that connects to an external electrical unit is integrated with the shift position detecting device and the control unit, and since this connector portion is connected to the control board through the connecting board, by forming the connecting board into a shape corresponding to the layout of the shift position detecting device, the control unit, and the connector portion, the electrical connection between the control unit, and the shift position detecting device and the connector portion can be carried out more flexibly and securely by the connecting board, regardless of the layout.

Moreover, since the control apparatus with shift position detecting device according to the present invention is provided with a first connector portion that connects to an electrical unit within the power train and a second connector portion that connects to a vehicle system outside the power train, communication between the electrical unit within the power train and the vehicle system outside the power train can be executed securely and flexibly through a simple structure, by using the connecting board that corresponds to the layout of the control unit and the connector portions.

Moreover, since, in the control apparatus with shift position detecting device according to the present invention, the shape of the connecting board conforms to the quadrangular shape of the control board, dead space in the casing generated by forming the control board into the quadrangular shape can be utilized effectively.

Moreover, since, in the control apparatus with shift position detecting device according to the present invention, the connecting board which connects the control board with the shift position detecting device is different from the connecting board which connects the control board with the connector portion, electrical connection between the control board and the shift position detecting device and electrical connection between the control unit and connector portion can be achieved more flexibly and securely, in accordance with the layout of the shift position detecting device, the control unit and the connector portion.

Moreover, since, in the control apparatus with shift position detecting device according to the present invention, at least two connecting boards of the connecting board for connecting the shift position detecting device to the control board, the second connecting board for connecting the first connector portion to the control board and the third connecting board for connecting the second connector portion to the control board, are formed from a common single board, the quantity of components in the connecting boards can be reduced, thereby achieving a reduction in cost.

Moreover, since, in the control apparatus with shift position detecting device according to the present invention, the connecting board is formed in a shape corresponding to the quantity of terminals of the output portion of the shift position detecting device, the connecting board can be formed flexibly to correspond to the quantity of the terminals of the output portion of the shift position detecting device, thereby enabling dead space in the casing generated by the quantity of the terminal of the output portion to be utilized effectively.

Moreover, since, in the control apparatus with shift position detecting device according to the present invention, the connecting board is formed into a shape corresponding to the quantity of the terminals of at least one of the first connector portion and the second connector portion, the connecting board can be formed flexibly to correspond to the quantity of the terminals in the connector portion, thereby enabling dead space in the casing generated by the quantity of these terminals to be utilized effectively.

Moreover, since, in the control apparatus with shift position detecting device according to the present invention, the shift position detecting device and the first connector portion are disposed in the vicinity of the long side of the rectangular control board while the second connector portion is disposed in the vicinity of the short side of the control board, the shift position detecting device, and the first and the second connector portions can be disposed effectively in terms of space, thereby enabling the control apparatus with shift position detecting device to be formed more effectively in a compact configuration.

Moreover, since, in the control apparatus with shift position detecting device according to the present invention, a connecting portion of the first connector and the control unit laps a side of the shift position detecting device, the arrangement of the connecting portion and the shift position detecting device can be shortened in the extended direction, thereby enabling the control apparatus with shift position detecting device to be formed in a more compact configuration.

Moreover, since, in the control apparatus with shift position detecting device according to the present invention, the shift position detecting device containing the projection portion is arranged such that the major axis of the sectional shape thereof and the long side of the control unit are parallel or substantially parallel, the shift position detecting device and the control unit can be arranged effectively in terms of space, thereby enabling the control apparatus with shift position detecting device to be formed more effectively in a compact configuration.

Moreover, in the control apparatus with shift position detecting device according to the present invention, the first and second connector portions can be arranged effectively to conform to the sides of the quadrangular control board.

Moreover, since, in the control apparatus with shift position detecting device according to the present invention, the connector portion that connects to an electrical unit outside the casing has a stress absorption and alleviating portion, when, for example, a stress such as thermal stress due to heat from the A/T is applied to a connecting terminal of the connector portion, this stress can be absorbed and alleviated by the stress absorption and alleviating portion, thereby preventing generation of an excessive stress such as a concentration of stress.

Further because the power train of the present invention employs any of the aforementioned control apparatuses with the shift position detecting device, at least one of the control unit and the connector portion can be laid out freely. Regardless of the shape of each of the shift position detecting device, control unit and connector portions, or regardless of the layout of the shift position detecting device, the control unit and the connector portions, electrical connection thereof can be achieved flexibly and securely. Therefore, the present invention is able to provide a highly versatile power train.

### BRIEF DESCRIPTION OF THE DRAWINGS

FIG. 1 is a diagram showing schematically an electrical connection structure in an A/T, which is one of the power trains adopting a first example of an embodiment of a control apparatus with shift position detecting device according to the present invention;
FIG. 2 is a plan view showing the control apparatus with shift position detecting device of the first example shown in FIG. 1;
FIG. 3 is a sectional view taken along the line III-III in FIG. 2;
FIG. 4 shows the control apparatus with shift position detesting device of the first example, where (a) is a sectional view taken along the line IV-IV in FIG. 2, and (b) is a partially enlarged sectional view of (a);
FIG. 5 shows a connector portion for A/T connecting of the first example, where (a) is a sectional view thereof, and (b) is a partially enlarged sectional view of a portion VB in (a);
FIG. 6 is an enlarged sectional view of a female connector in FIG. 5;
FIG. 7 shows a second example of an embodiment of the control apparatus with shift position detecting device according to the present invention, where (a) is a plan view thereof, and (b) is a sectional view taken along the line VIIB-VIIB in (a);
FIG. 8 shows schematically a portion of a third example of an embodiment of the present invention, where (a) is a top view thereof, and (b) is a front view;
FIG. 9 shows a joint portion between a pad of a control board and through holes of a connecting board of the third example, where (a) is a diagram showing a state before the control board and the connecting board are bonded together, and (b) is a diagram showing a state where the control board and the connecting board are bonded together;
FIG. 10 shows a joint portion between a circuit board and a wiring board, where (a) is an enlarged diagram of a portion XA in FIG. 9 (b), and (b) is the same diagram as (a), but showing a state where soldering has been carried out;
FIG. 11 shows schematically a portion of a fourth example of an embodiment of the present invention, where (a) is the same diagram as FIG. 9 (a) showing a state before the control board and the connecting board are bonded together, (b) is the same diagram as FIG. 9 (b) showing a state where the control board and the connecting board are bonded together, and (c) is the same diagram as FIG. 10 (b) showing a state where soldering has been carried out;
FIG. 12 shows schematically a portion of a fifth example of an embodiment of the present invention, where (a) is the same diagram as FIG. 11 (a) showing a state before the control board and the connecting board are bonded together, (b) is the same diagram as FIG. 11 (b) showing a state where the control board and the connecting board are bonded together, and (c) is the same diagram as FIG. 11 (c) showing a state where soldering has been carried out;
FIG. 13 shows schematically a portion of a sixth example of an embodiment of the present invention, where (a) is the same diagram as FIG. 11 (a) showing a state before the control board and the connecting board are bonded together, (b) is the same diagram as FIG. 11 (b) showing a state where the control board and the connecting board are bonded together, and (c) is the same diagram as FIG. I 1 (c) showing a state where soldering has been carried out;
FIG. 14 is a plan view showing a seventh example of an embodiment of the control apparatus with shift position detecting device according to the present invention; and
FIG. 15 is a diagram showing schematically and conceptually this kind of electrical connection between an electrical unit and an ECU in a conventional automatic transmission.

### BEST MODE FOR CARRYING OUT THE INVENTION

Hereinafter, the best mode for carrying out the present invention will be described with reference to the accompanying drawings.

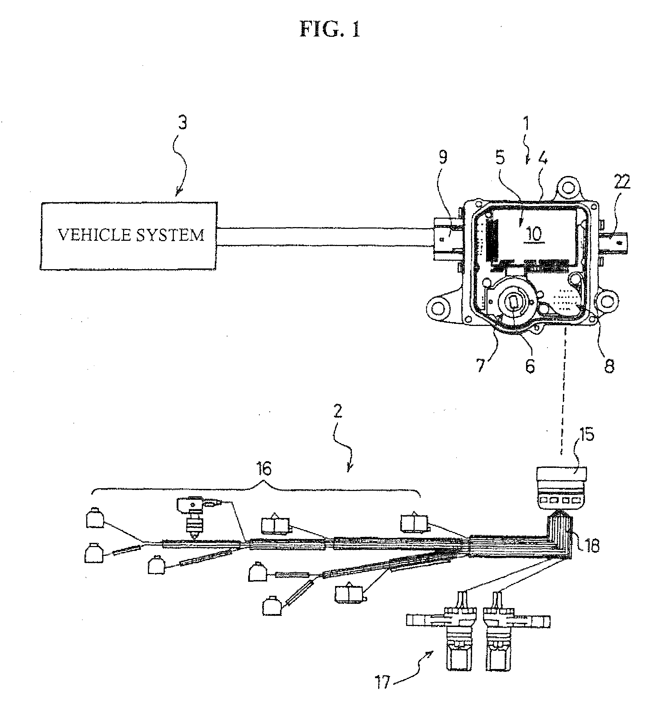

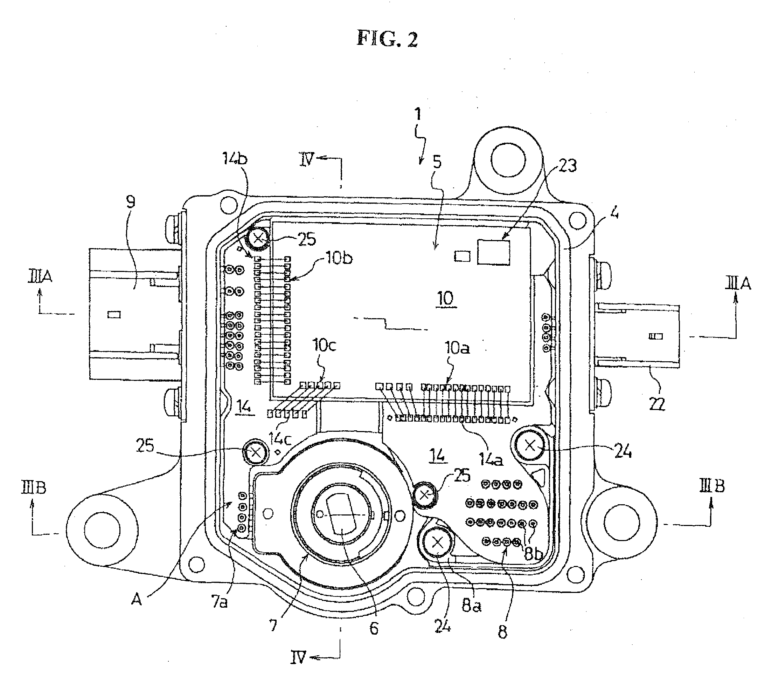

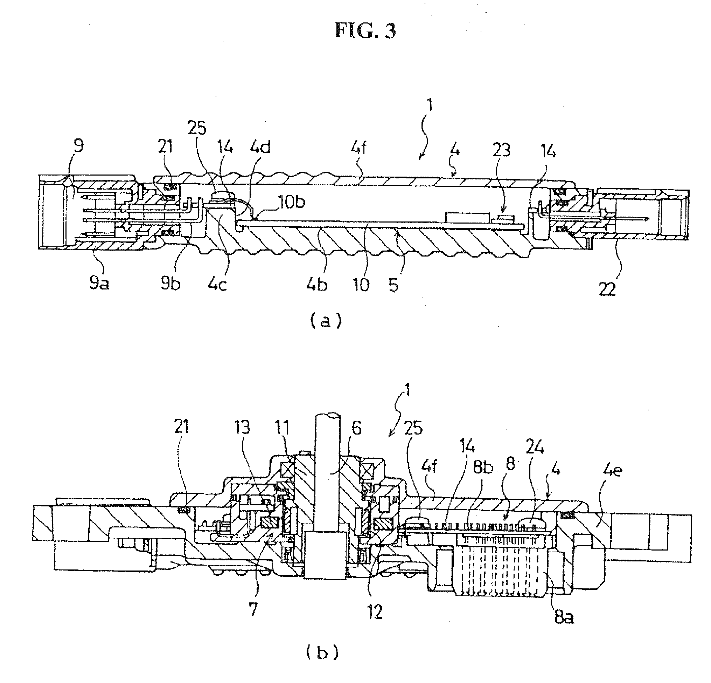

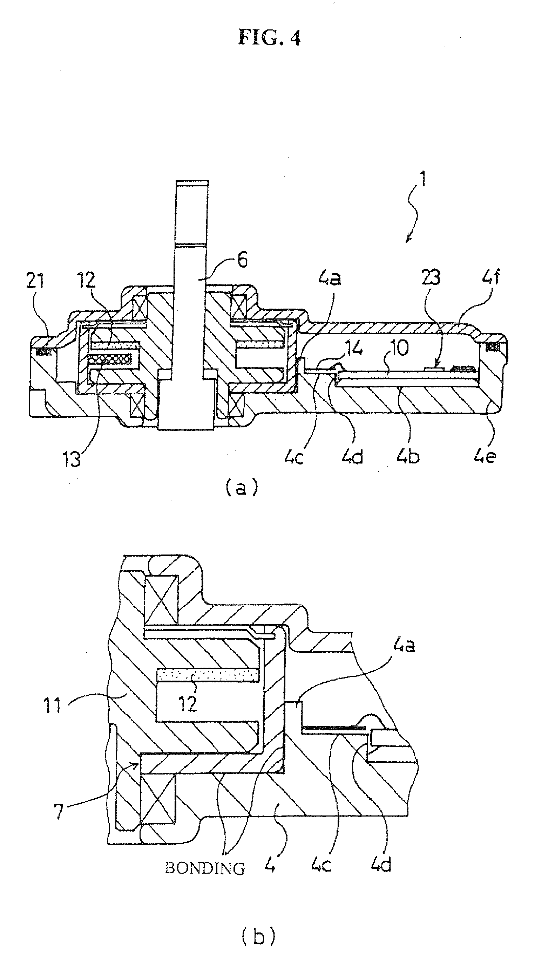

FIG. 1 is a diagram showing schematically an electric connection structure in an A/T, which is one of the power trains adopting a first example of an embodiment of a control apparatus with shift position detecting device according to the present invention. FIG. 2 is a plan view showing the control apparatus with shift position detecting device of the first example. FIG. 3 is a sectional view taken along the line III-III in FIG. 2. FIG. 4 shows the control apparatus with shift position detecting device of the first example, where (a) is a sectional view taken along the line IV-IV in FIG. 2, and (b) is a partially enlarged sectional view of (a). Note that the shift positions referred to here may be, for example, park (P), reverse (R), neutral (N), drive (D) and the like. Furthermore, although FIGS. 4 (a) and (b) show an example where the arrangement structure of a permanent magnet and a magnetic sensor in the shift position detecting device is different from the arrangement structure of those shown in FIG. 3 (b), the function of the permanent magnet and the magnetic sensor shown in FIGS. 4 (a) and (b) are completely the same as the function of the permanent magnet and magnetic sensor shown in FIG. 3 (b), and this arrangement structure is not characteristic of the present invention in terms of structure.

As shown in FIG. 1, in the electric connection structure of the A/T of the first example, an A/T 2 controlled by a control apparatus with shift position detecting device 1 and a vehicle system 3 which supplies the control apparatus with shift position detecting device 1 with vehicle running information and is supplied with an A/T shift position signal, a starter drive signal and a reverse lighting signal from the A/T 2 and the control apparatus with shift position detecting device 1, are electrically connected to the control apparatus with shift position detecting device 1.

As shown in FIGS. 2, 3 (a), and 3 (b) in detail, the control apparatus with shift position detecting device 1 includes a casing 4. An ECU 5 for controlling a speed change in the A/T and a shift position detecting device 7, which is operated by shift lever operation, shift switch operation, shift dial operation, or the like by a vehicle driver, for detecting a rotati on position of a manual shaft 6 (corresponding to a shift unit of the present invention) of the A/T which changes in accordance with this operation are provided in the casing 4. Further, a connector 8 for connecting with the A/T (corresponding to a first connector portion of the present invention) which is inserted in the same direction as the insertion direction of the manual shaft 6 and is connected to a solenoid, a sensor or the like in the A/T, a connector 9 for connecting with the vehicle system to which a vehicle running condition detection signal such as for engine speed, engine cooling water temperature and the like is inputted from an engine ECU for controlling, for example, an engine, and a speed sensor connector 22 are provided in the casing. An external electric device referred to in the present invention may be at least any one or all of a solenoid and a sensor in the A/T, or an engine ECU disposed outside the A/T.

The ECU 5 has a rectangular control board 10 comprised of, for example, a ceramic board or the like having a higher heat resistance and heat dissipation capacity than a connecting board 14, which will be described later, in order to improve environment resistance reliability. A plurality of circuit chips (devices) 23 comprised of mainly microcomputers are disposed on this control board 10 and each circuit chip includes, for example, terminal groups 10a, 10b, and 10c disposed along two sides of the control board 10. Then, the control board 10 is fixed on the casing 4 over its entire face with an adhesive agent. If the control board 10 is fixed on the casing 4 with bolts, however, there is the possibility that a bolt fixing section of the ceramic board may be damaged by vibration or the like, and by bonding over the entire face in this way, such damage can be prevented effectively and heat generated in the devices 23 can be released to the casing 4 from the control board 10 through the adhesive agent, thereby increasing the heat dissipation effect. In the meantime, one side referred to in the present invention refers to a side that is straight or substantially straight.

The control board 10 is composed of an insulator and wiring connected electrically to a device provided on the board 10, and the aforementioned material is insulating material.

As shown in FIG. 3 (b), the shift position detecting device 7 includes a movable unit 11 which is fixed on the manual shaft 6 and is integrally rotatable with the manual shaft 6, a permanent magnet 12 (corresponding to magnetic field generating means of the present invention) which is fixed on the movable unit 11 and is integrally rotatable with the movable unit 11, and a magnetic sensor 13, such as a Hall element (Hall IC) or the like, which detects changes in magnetic field due to rotation of the permanent magnet 12 without contact with the permanent magnet 12 and generates, for example, an electromotive force.

Therefore, if the manual shaft 6 is rotated corresponding to a shift operation performed by the vehicle driver, the relative position of the permanent magnet 12 and the magnetic sensor 13 changes. That is, since the magnetic field of the permanent magnet 12 changes, the magnetic sensor 13 outputs a voltage value corresponding to the change in the magnetic field. Since the voltage value corresponds to a speed change range position established by the shift operation, the speed change range position can be detected by the voltage value.

As shown in FIG. 2, the shift position detecting device 7 is provided with an output circuit portion 7a (corresponding to an output portion of the present invention) that outputs a voltage signal from the magnetic sensor 13. The output circuit portion 7a is constructed of a board having a conductor, and this conductor is connected electrically to a conductor of the connecting board 14 so as to perform output from the output circuit portion 7a to the connecting board 14. In this case, the output circuit portion 7a and the connecting board 14 are disposed on the same plane. Edges of these components that oppose each other do not overlap in the vertical direction with respect to a plane on which the output circuit potion 7a and the connecting board 14 are disposed (the perpendicular direction with respect to the drawing in FIG. 2, and the vertical direction in FIG. 3 (a) and (b)), thereby reducing the thickness of the control apparatus with shift position detecting device 1. The connecting board 14 is fixed to the casing 4 with a bolt, and this fixing method is different from the previously described fixing method of the control board 10. The reason why the connecting board 14 is fixed with a bolt is that grounding (earth) is achieved using this bolt, and not so much consideration needs to be taken regarding heat dissipation because no device is disposed on the connecting board, unlike the control board 10.

As shown in FIG. 4 (a), the shift position detecting device 7 is disposed on the casing 4 based on a first wall 4a provided to surround the shift position detecting device 7, and is bonded to the first wall 4a, so that horizontal movement of the shift position detecting device 7 with respect to the casing 4 is restricted by the first wall 4a.

The casing 4 includes a body portion 4e and a cover portion 4f which closes a top end opening portion of the body portion 4e. The shift position detecting device 7 is held between the body portion 4e and the cover portion 4f so that movement perpendicular to the casing 4 (the vertical direction in FIG. 4 (a)) is restricted. Further, a space between the body portion 4e and the cover portion 4f is sealed on the same plane by a sealing member 21.

The connecting board 14, having a shape substantially covering a portion of the casing 4 except a plane on which the control board 10 of the ECU 5 and the shift position detecting device 7 are disposed, and which is formed with a predetermined wiring circuit (not shown), is disposed within the casing 4. In this case, a space in the casing 4 other than a space in which the control board 10 and the shift position detecting device 7 are disposed is substantially occupied by the connecting board 14. Further, the control board 10 and the connecting board 14 are disposed on the same plane so that edges opposing each other do not overlap in a vertical direction (as described previously) with respect to a plane in which the control board 10 and the connecting board 14 are disposed, thereby reducing the thickness of the control apparatus with shift position detecting device 1.

The connecting board 14 is composed of a flexible board which is easier to process than a ceramic board, and is formed to conform to a shape that includes a long side and a short side of the rectangular control board 10 (this is not restricted to a rectangular shape, but may also be square) as well as being formed into a shape that has a curved face conforming with the circular shape of the circular cross section of the shift position detecting device 7. Further, the connecting board 14 is formed to have a shape in accordance with a terminal group (not shown) of the output circuit portion 7a of the shift position detecting device 7 and the connector 8 for connecting with the A/T that is provided in the vicinity of the long side of the control board 10 as described later, and the number of terminals of circuit terminal groups 14a and 14b connected respectively to the connector 9 for connecting with the vehicle system that is provided in the vicinity of the short side of the control board 10. That is, its shape is determined in accordance with the number of terminals of the connectors 8 and 9.

Additionally, the connecting board 14 is composed of material easier to process and cheaper than the control board 10, for example, a glass cloth epoxy board (hereinafter may also be referred to as a glass epoxy board), a flexible board or the like. Easy to process material refers to material which may be cut in a complicated shape, such as a curved shape or a bent line shape as opposed to a straight shape when cut from a single board, and the composition of the easy to process material is soft. This definition regarding the easy to process material may also be applied to the control board 10, which is also composed of easy to process material and will be described later. The shift position detecting device 7 and the control board 14 are separated from each other by the first wall 4a.

On the connecting board 14, three circuit terminal groups 14a, 14b, and 14c are disposed along and in the vicinity of the two sides, the long side and the short side, of the control board 10, in accordance with three circuit terminal groups 10a, 10b, 10c of the control board 10. The respective circuit terminals of the circuit terminal groups 14a, 14b, and 14c may be connected electrically to the magnetic sensor 13 of the shift position detection device 7, and any one of a number of input/output terminals of the connector 8 for connecting with the A/T and the connector 9 for connecting with the vehicle system through the wiring of the connection board 14.

The connecting board 14 is composed of a relatively soft easy to process material as described above, so that it may be formed into any shape. Consequently, it can conform flexibly and easily with the layouts of the ECU 5, the shift position detecting device 7, the connector 8 for connecting with the A/T, and the connector 9 for connecting with the vehicle system, so that no dead space is generated in the casing 4, and the interior of the casing 4 can be used more effectively.

As shown in FIGS. 4 (a) and (b), a concave and convex surface is formed on mounting portions for the control board 10 and the connecting board 14 in the casing 4. That is, a portion to which the control board 10 is to be mounted is a concave portion 4b while a portion to which the connecting board 14 is to be mounted is a convex portion 4c. Then, by adjusting and setting the size of the concavity and convexity in accordance with the thickness of each of the control board 10 and the connecting board 14, the top face of the control board 10 and the top face of the connecting board 14 can be set on substantially the same plane, as shown in the diagram. Further, although not shown, the height of the convex portion 4c to which the connecting board 14 is mounted may be set so as to enable the magnetic sensor 13 and the wiring of the connecting board 14 to be on substantially the same plane. The concave portion 4b and the convex portion 4c therefore form a plane adjusting portion for adjusting the heights of the boards to substantially the same plane in the casing 4.

By adjusting the top face of the control board 10 and the top face of the connecting board 14 to substantially the same plane in this way, electrical connection between a circuit terminal of the control board 10 and a circuit terminal of the connecting board 14, and electrical connection between the magnetic sensor 13 and the wiring of the connecting board 14 can be achieved securely and easily.

Furthermore, a step portion between the concave portion 4b and the convex portion 4c is formed in an L shape, forming a second wall 4d which surrounds part of the control board 10. Thus, the first wall 4a and the second wall 4d form the wall of the present invention that is located between the shift position detecting device 7 and the control board 10.

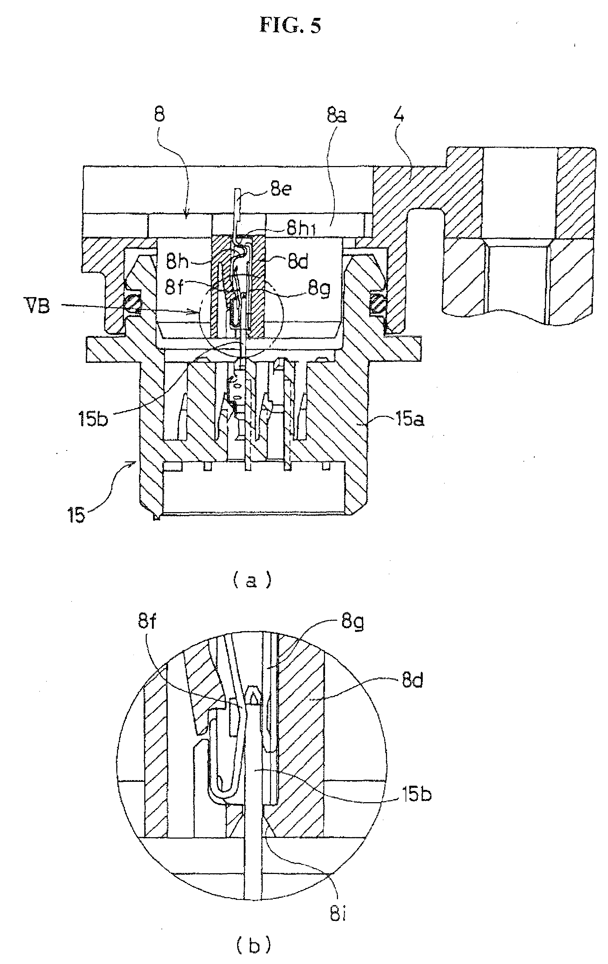

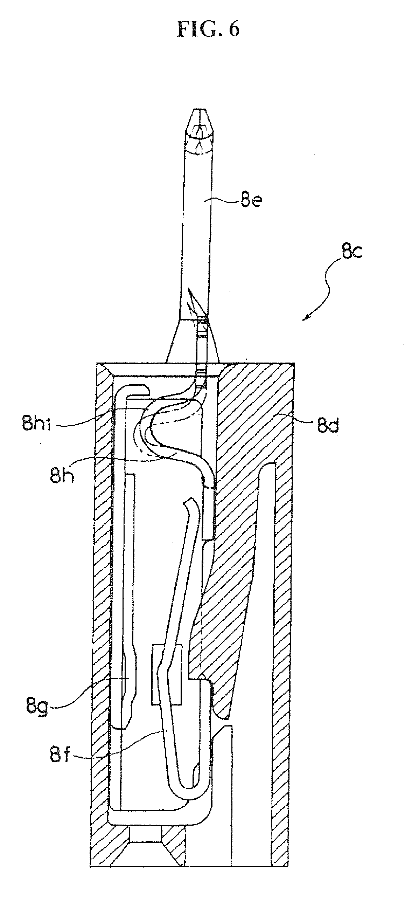

As shown in FIGS. 3 (b) and 5 (a), the connector 8 for connecting with the A/T is includes a connector cover 8a provided on the casing 4 and a connector portion 8b that connects to the connecting board 14 through the connector cover 8a. The connector portion 8b has 22 female connectors in the example shown in FIG. 2 and these female connectors all have the same structure. Note that FIG. 5 (a) shows only one female connector. As shown in FIG. 6, the female connector 8c includes a connector main body 8d fixed on the connector cover 8a, a connecting terminal 8e fixed on a top end of the connector main body 8d, a first contact portion 8f which is composed of a conductive belt-like plate fixed on the connector main body 8d, a second contact portion 8g which is composed of a conductive belt-like plate fixed on the connector main body 8d with a predetermined clearance relative to the first contact portion 8f, and a conductor 8h which connects the connecting terminal 8e with the first contact portion 8f. In this case, the conductor 8h is provided with a stress absorption and alleviation portion 8h₁ which is curved in a U shape. When a stress such as thermal stress caused by heat of the A/T is applied to the connecting terminal 8e, the stress absorption and alleviating portion 8h₁ distorts as indicated by the single dashed line so that the connecting terminal 8e displaces as indicated by the single dashed line to absorb and alleviate the stress, so that an excessive stress such as stress concentration is not generated.

Note that the aforementioned structure of the connector 8 for connecting with the A/T including the stress absorption and alleviating portion 8h₁ can be applied to the other connector 9 for connecting with the vehicle system, and the speed sensor connector 22.

In the connector 8 for connecting with the A/T, the resin connector cover 8a is fixed to the casing 4 from both sides with a bolt 24 in order to improve sealing performance. Then, the connecting board 14 is provided so as to cover the resin connector cover 8a, and is fixed to the casing 4 with a bolt 25. Due to this sealing material, however, the connecting board 14 is provided in a raised position at a predetermined height from the casing 4 in another circuit portion.

The speed sensor connector 22 is for connection with a speed sensor (not shown) provided on an outside face of an A/T case. Because it cannot be provided together with the connector 8 for connecting with the A/T that connects with electrical units within the A/T case, the connector 8 for connecting with the A/T is provided separately from the speed sensor connector 22.

As shown in FIG. 1, the connector 8 for connecting with the A/T is connected electrically and directly to an A/T side connector 15, which is a male connector fixed to the A/T case (not shown). That is, as shown in FIG. 5 (a), a connector cover 15a of the A/T side connector 15 is sealed by the connector cover 8a of the A/T connecting connector 8 such that both fit to each other. In this case, as shown by the enlargement in FIG. 5 (b), a connecting terminal 15b of the A/T side connector 15 passes through an insertion hole 8i in the connector main body 8d corresponding to the connecting terminal 15b of the female connector 8c, so that it enters between the first contact point 8f and the second contact point 8g and pushes apart the clearance between the first contact point 8f and the second contact point 8g. Thus, the connecting terminal 15b of the A/T side connector 15 is pressed by the first and second contact portions 8f and 8g, so that the connecting terminal 15b of the A/T side connector 15 is electrically connected to the connecting terminal 8e of the connector 8 for connecting with the A/T.

A wire harness 18 that collects together respectively the wiring of various kinds of sensors 16 in the A/T case and the wiring of solenoids 17 provided additionally on the valve body in the A/T case is connected to the A/T side connector 15.

As shown in FIG. 3 (a), the connector 9 for connecting with the vehicle system is includes a connector cover 9a provided on the casing 4, and a connector portion 9b that connects to the connecting board 14 through the connector cover 9a. As shown in FIG. 1, the connector portion 9b of the connector 9 for connecting with the vehicle system is connected to the vehicle system 3 and, as described above, a vehicle running condition detection signal such as for engine speed, engine cooling water temperature and the like is inputted from the engine ECU for controlling the engine.

Since, in the control apparatus with shift position detecting device 1 of the first example having such a structure, the shift position detecting device 7, the A/T connecting connector 8 and the connector 9 for connecting with the vehicle system are connected to the ECU 5 through the connecting board 14, the shift position detecting device 7, both the connector 8 and the connector 9 for connecting with the vehicle system, and the ECU 5 can be laid out freely in the casing 4.

Therefore, since layout can be freely carried out in this way, the wiring pattern and the circuit pattern of the ECU 1 do not need to be redesigned for each type of A/T, thereby preventing an increase in cost and increasing versatility.

Furthermore, since the control board 10 is constituted by a board having a high heat dissipation capacity, heat from the devices mounted on the control board can be dissipated effectively.

Moreover, since the control board 10 is constituted by a board having a high heat resistance, reduction in durability caused by heat from the devices or by heat within the engine room can be prevented.

Moreover, by forming the connecting board 14 at a cheaper price than the control board 10, an increase in cost can be prevented, and since a board capable of achieving a more accurate control can be used for the control board 10 in which the devices are disposed, control reliability can be secured.

Moreover, by using a ceramic board for only the control board in which the devices are disposed, the heat dissipation capacity and the heat resistance can be improved, thereby minimizing increases in cost.

Moreover, since a flexible board is employed for the connecting board 14, deviation (manufacturing error of a component or installation error of a component) of a component when electrically connected can be absorbed due to the flexibility of the board material, and even if, for example, the control apparatus with shift position detecting device 1 is placed under in an extremely severe thermal environment such as an engine room, and at least one of the shift position detecting device and connector portion that connects to the connecting board expands or contracts due to the heat therein, that expansion or contraction can be absorbed effectively due to the flexibility of the board material.

Moreover, since the connecting board 14 is constituted by a glass epoxy board, connecting means can be formed cheaply, thereby preventing an increase in cost of the control apparatus with shift position detecting device 1.

Since the shift position detecting device 7 is constituted by a non-contact type shift position detecting device, it is not necessary to provide a contact for each shift position, unlike with a contact-type shift position detecting device, thereby enabling the apparatus to be constructed in a compact shape.

Further, an advantage of the non-contact type shift position detecting device 7 is that since metallic powder or the like, generated by contact friction with grease that would be applied to a contact does not occur, an adverse effect on the control board 10 can be prevented.

Moreover, since the output of the magnetic sensor 13 changes continuously when the magnetic field of the permanent magnet 12 changes in accordance with an operation by the vehicle driver, the shift position can be detected continuously.

Moreover, since the output circuit portion 7a for outputting a signal from the magnetic sensor 13 is connected to the connecting board 14, the magnetic sensor 13 and the connecting board can be connected together easily.

Moreover, since the control board 10 and the connecting board 14 do not overlap each other in a vertical direction with respect to the plane in which the control board 10 is disposed, the connecting portion between the control board 10 and the connecting board 14 can be made thinner, thereby enabling the control apparatus with shift position detecting device 1 to be formed more compact by that amount.

Moreover, since the shift position detecting device 7 and the control board 10 do not overlap each other on the same plane, the control apparatus with shift position detecting device 1 can be made thinner over its entirety and consequently, when the control apparatus with shift position detecting device 1 is mounted at various kinds of positions, interference with other devices can be prevented. Further, because the control board 10 does not overlap the shift, position detecting device 7, the control board 10 can be replaced easily.

Because the shift position detecting device 7 and the control board 10 do not overlap each other in a vertical direction with respect to the plane in which the control board 10 is disposed, the control apparatus with shift position detecting device 1 can be made thinner over its entirety and, consequently, when the control apparatus with shift position detecting device 1 is mounted at various kinds of positions, interference with other devices can be prevented.

Moreover, even if the height of the shift position detecting device 7, the height of the control board 10 and the height of the connecting board 14 are different, the heights thereof can be adjusted by the concave and convex portions 4 and 4c, which constitute the plane adjusting portion. By carrying out this height adjustment, the shift position detecting device 7, the control board 10 and the connecting board 14 can be arranged on the same plane, thereby facilitating connection with the connecting board 14.

Moreover, since the walls 4a and 4d are provided on the casing 4 between the shift position detecting device 7 and the control board 10, the shift position detecting device 7 and the control board 10 can be disposed based on these walls 4a and 4d, thereby improving operability. Additionally, movement of the shift position detecting device 7 and the control board 10 in a horizontal direction with respect to the casing 4 can be restricted by the walls 4a and 4d. Furthermore, since foreign material such as minute particles of dirt or the like generated from the shift position detecting device 7 are blocked by the walls 4a, 4d, an adverse effect on the control board 10 caused by this foreign material can be prevented.

Moreover, since the shift position detecting device 7 is held by the body portion 4e and the cover portion 4f of the casing 4, the shift position detecting device 7 can be fixed to the casing 4 even without additional provision of a member for restricting vertical movement of the shift position detecting device 7 with respect to the casing 4, thereby preventing an increase in cost..

Moreover, since sealing between the body portion 4e and the cover portion 4f is accomplished on the same plane, the sealing can be executed effectively, thereby enabling the sealing performance to be improved and the sealing to be carried out easily.

Moreover, as shown by enlargement in FIG. 4 (b), the shift position detecting device 7 can be bonded so that horizontal movement thereof with respect to the casing 4 is restricted by the first wall 4a, and so that vertical movement thereof with respect to the board is restricted by the casing 4. That is, a multiplier effect caused by bonding along two directions, the horizontal direction and the vertical direction, which are orthogonal to each other, enables the bonding strength of the shift position detecting device 7 to be intensified.

Moreover, since the easy to process connecting board 14 is connected to the shift position detecting device 7 and the ECU 5, the connecting board 14 can be connected to the shift position detecting device 7 and the ECU 5 in accordance with the shape of the shift position detecting device 7 and the shape of the ECU 5. Therefore, regardless of the shape of the shift position detecting device 7 and the shape of the ECU 5, electrical connection can be achieved flexibly and securely

Moreover, by conforming the external shape of the connecting board 14 with the circular sectional shape of the shift position detecting device 7, dead space (for example, portion A in FIG. 2) in the casing 4 can be employed more effectively by the connecting board 14.

Moreover, since a space in the casing 4 other than a space in which the control board 10 and the shift position detecting device 7 are disposed is substantially occupied by the connecting board 14, the other dead space in the casing 4 can be used effectively.

Moreover, since the shift position detecting device 7 or the ECU 5 is connected by the connecting board 14 that is easier to process than the control board 10, regardless of the shape of the shift position detecting device 7 or the ECU 5, by processing the shape of the connecting board 14 so that it conforms to the shape of the shift position detecting device 7 or the ECU 5, the connection with the shift position detecting device 7 or the ECU 5 can be carried out along these shapes more flexibly and easily.

Moreover, since the control board 10 and the shift position detecting device 7 are connected through the connecting board 14, the connecting board 14 can be connected to the shift position detecting device 7 or the control board 10 easily by conforming it with these shapes.

Moreover, since the connector 8 for connecting with the A/T that connects to an electrical unit outside the casing 4, and the connector 9 for connecting with the vehicle system are integrated with the shift position detecting device 7 and the ECU 5, and the connectors 8 and 9 are connected to the control board 10 through the connecting board 14, by forming the connecting board 14 into a shape corresponding to the layout of the shift position detecting device 7, the ECU 5, and both the connectors 8 and 9, the electrical connection between the ECU 5, and the shift position detecting device 7 and both the connectors 8 and 9 can be carried out more flexibly and securely by the connecting board 14, regardless of the layout.

Moreover, since the connector 8 for connecting with the A/T that connects to an electrical unit in the A/T and the connector 9 for connecting with the vehicle system that connects to the vehicle system 3 outside the A/T are provided separately, communication between the electrical unit within the A/T and the vehicle system 3 outside the A/T can be executed securely and flexibly through a simple structure by using the connecting board 14 that corresponds to the layout of the ECU 5 and both the connectors 8 and 9.

Moreover, since the shape of the connecting board 14 conforms to the rectangular shape of the control board 10, dead space in the casing 4 generated by forming the control board 10 into the rectangular shape can be utilized effectively.

Moreover, since the connecting board for connecting the shift position detecting device 7 to the control board 10, the connecting board for connecting the connector 8 for connecting with the A/T to the control board 10, and the connecting board for connecting the connector 9 for connecting with the vehicle system to the control board 10 are formed from a common single board, the quantity of components can be reduced thereby achieving a reduction in cost.

Moreover, since the connecting board 14 is formed into a shape corresponding to the quantity of terminals of the output circuit portion 7a of the shift position detecting device 7, the connecting board 14 can be formed flexibly to correspond to the quantity of the terminals of the output circuit portion 7a of the shift position detecting device 7, thereby enabling dead space in the casing 4 generated by the quantity of the terminals of the output circuit portion 7a to be utilized effectively. Furthermore, regarding the terminal 14a, although the quantity of the terminals increases or decreases in accordance with the quantity of the solenoids or the quantity of the sensors provided in the A/T, in order to ensure versatility with regards to the various kinds of A/Ts, provision of a lapping portion may be considered at the design stage to provide a margin for the terminal 14a.

Moreover, since the connecting board 14 is formed into a shape corresponding to the quantity of the terminals of each of the connector 8 for connecting with the A/T and the connector 9 for connecting with the vehicle system, the connecting board 14 can be formed flexibly to correspond to the quantity of the terminals in the connectors 8 and 9, thereby enabling dead space in the casing generated by the quantity of these terminals to be utilized effectively.

Further because the shift position detecting device 7 and the connector 8 for connecting with the A/T are disposed in the vicinity of the long side of the rectangular control board 10 while the connector 9 for connecting with the vehicle system is disposed in the vicinity of the short side of the control board 10, the shift position detecting device 7 and both the connectors 8 and 9 can be disposed effectively in terms of space, and consequently, thereby enabling the control apparatus with shift position detecting device 1 to be formed more effectively in a compact configuration,

Moreover, the A/T 2 of this example can achieve electrical connection flexibly and securely regardless of the shape of each of the shift position detecting device 7, the ECU 5 and both the connectors 8 and 9, or regardless of the layout of the shift position detecting device 7, the ECU 5 and both the connectors 8 and 9, thereby obtaining an A/T 2 having high versatility.

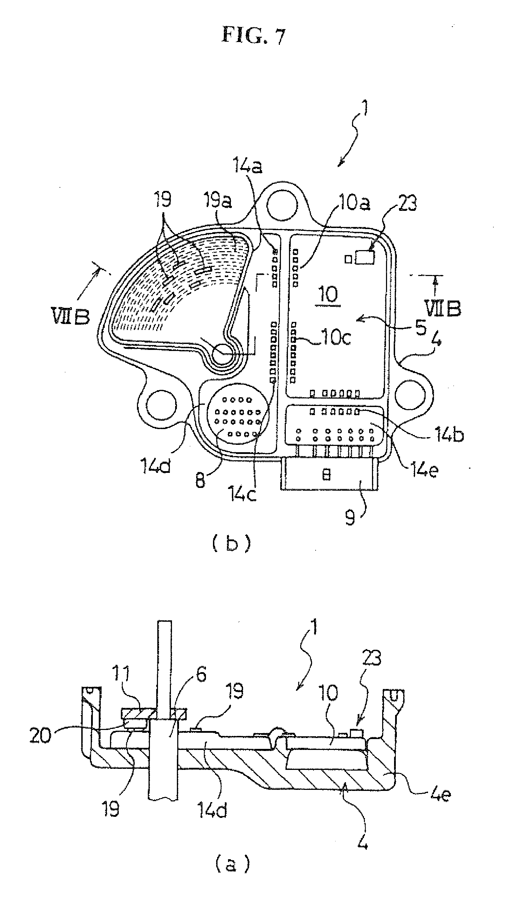

FIG. 7 shows a second example of an embodiment of the control apparatus with shift position detecting device according to the present invention, where FIG. 7 (a) is a plan view thereof, and FIG. 7 (b) is a sectional view taken along the line VIIB-VIIB of FIG. 7(a). In the description of each example of the embodiments below, identical reference numerals are attached to the same structural components as those described in the previous example and detailed description thereof is omitted.

Although the aforementioned first example concerns a non-contact type shift position detecting device 7, the control apparatus with shift position detecting device 1 of the second example, as shown in FIGS. 7 (a) and (b), includes a well-known contact type shift position detecting device 7 which is conventionally used in general as a shift position detecting device (the shift position detecting device described in the aforementioned patent publication is a contact-type shift position detecting device). This contact-type shift position detecting device 7 is constituted by a predetermined number of fixed contacts 19 and a movable contact 20 which makes contact selectively with some of the fixed contacts 19 in accordance with the shift position, or makes no contact.

Furthermore, according to the second example, the connecting board 14 is divided into two different connecting boards 14d and 14e. One connecting board 14d is provided with the connector 8 for connecting with the A/T, the circuit terminal groups 14a and 14c of the ECU 5, and the fixed contact 19 of the shift position detecting device 7. In addition, the other connecting board 14e (corresponding to the second connecting board of the present invention) is provided with the connector 9 for connecting with the vehicle system, and the circuit terminal 14b of the ECU5.

Moreover, the connecting board 14d is provided with an output circuit portion 19a constituted by a conductor which makes contact with the fixed contact 19 and the circuit terminal group 14a so as to send an output of the contact-type shift position detecting device 7.

Further, the connecting board 14 is provided with a connecting portion (connecting portion between the circuit terminal group 10c and the circuit terminal group 14c) which connects the connector 8 for connecting with the A/T with the control board 10 of the ECU 5 so as to lap the side of the shift position detecting device 7 (the right side of the shift position detecting device 7 in FIG. 7 (a)).

Since, in the control apparatus with shift position detecting device 1 according to the second example that is structured in such a way, the control apparatus with shift position detecting device 1 can be achieved using the contact-type shift position detecting device generally used in the conventional A/T, and consequently the control apparatus with shift position detecting device 1 can be formed at a low price.

Moreover, since the connecting board 14d which connects the control board 10 with the shift position detecting device 7, and the connecting board 14e which connects the control board 10 with the connector 9 for connecting with the vehicle system are differentiated, electrical connection between the control board 10 and the shift position detecting device 7, and electrical connection between the control board 10 and the connector 9 for connecting with the vehicle system can be achieved more flexibly and securely in accordance with the layout of the shift position detecting device 7, the ECU 5 and the connector 9 for connecting with the vehicle system.

Moreover, since the connecting portion between the connector 8 for connecting with the A/T and the ECU 5 laps the side of the shift position detecting device 7, the arrangement of the connecting portion and the shift position detecting device 7 can be shortened in the extended direction (the vertical direction in FIG. 7 (a)), thereby enabling the control apparatus with shift position detecting device 1 to be formed in a more compact configuration.

Other structures and operational effects of the second example are substantially identical to the first example.

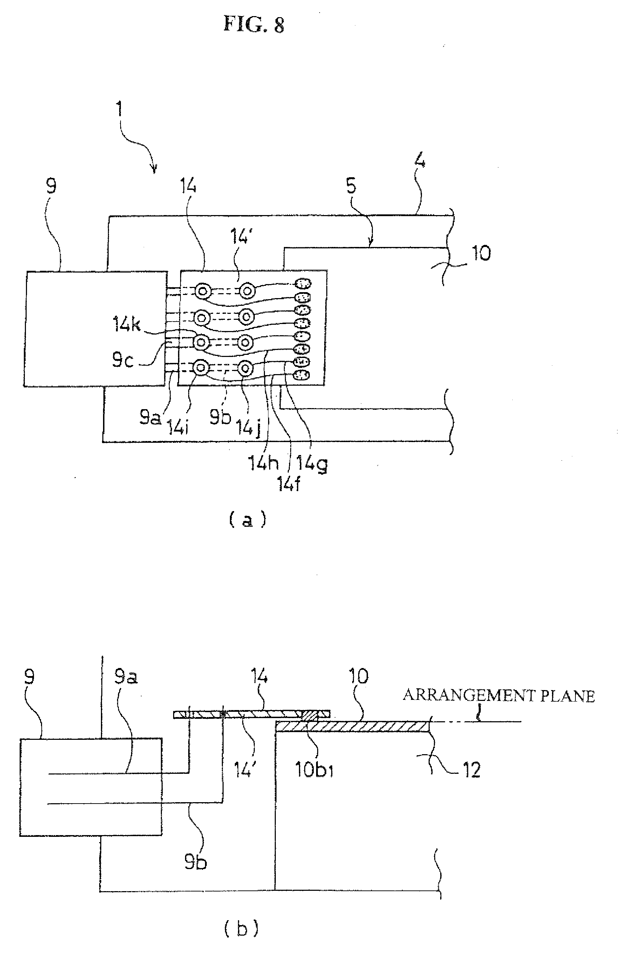

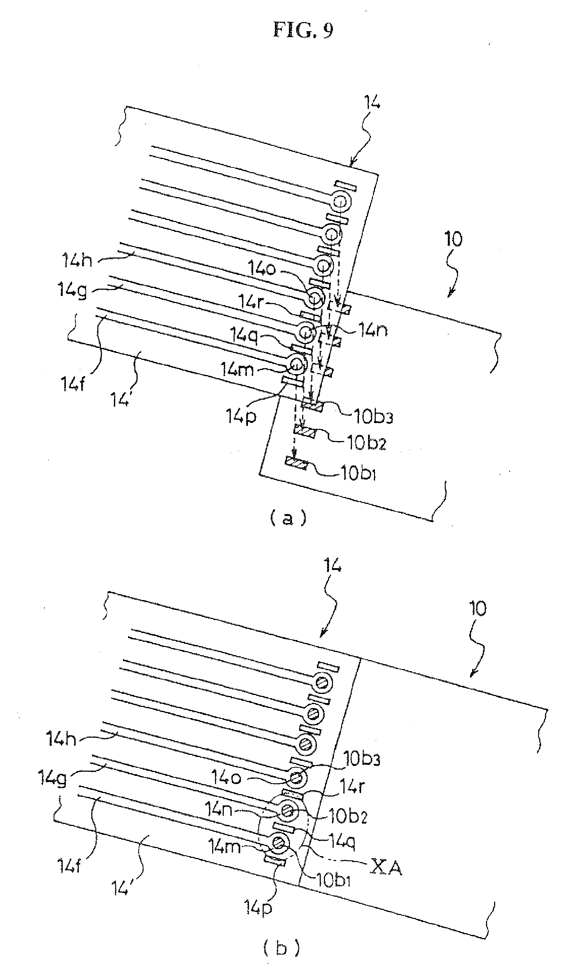

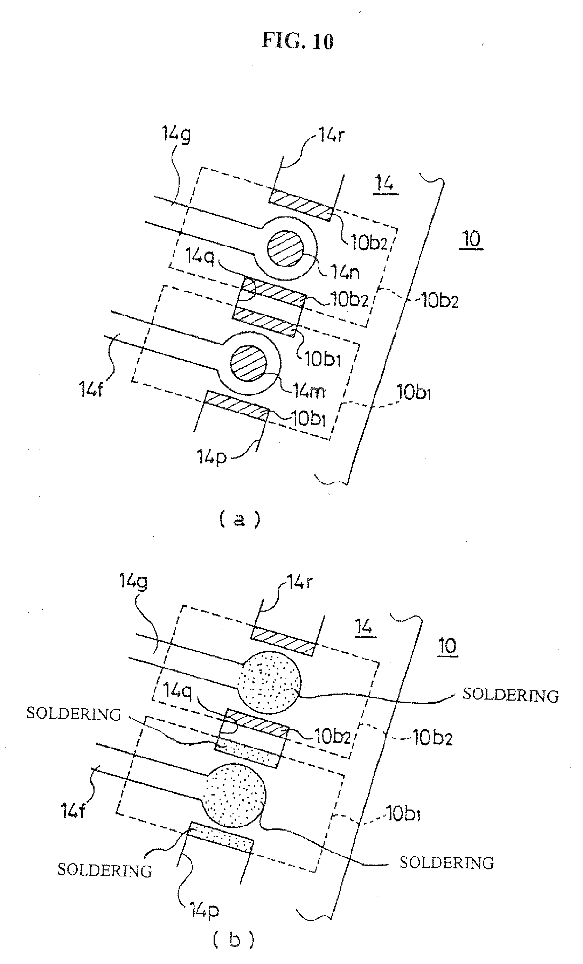

FIG. 8 shows schematically a portion of a third example of an embodiment of the present invention, where (a) is a top view thereof, and (b) is a front view. In addition, FIG. 9 shows a joint portion between a pad of the control board and through holes of the connecting board of this example, where (a) is a diagram showing a state before the control board and the connecting board are bonded together, and (b) is a diagram showing a state where the control board and the connecting board are bonded together. FIG. 10 shows a joint portion between the control board and the connecting board, where (a) is an enlarged diagram of a portion XA in FIG. 9 (b), and (b) is the same diagram as (a), but showing a state where soldering has been carried out.

As shown in FIG. 8, the control apparatus with shift position detecting device 1 of the third example includes the connecting board 14 comprised of a flexible printed circuit board (FPC). This connecting board 14 includes a circuit pattern composed of a predetermined quantity of conductors 14f, 14g, 14h, ... that are printed on the flexible printed circuit board 14' and held so as to be mutually insulated, a predetermined quantity of conductive connector side through holes 14i, 14j, 14k, ... that are connected electrically to an end of each of the respective conductors 14f, 14g, 14h, .... in this circuit pattern, a predetermined quantity of conductive control board side through holes 14m, 14n, 14o, ... that are connected electrically to the other end of each of the respective conductors 14f, 14g, 14h, and a predetermined quantity of confirmation holes 14p, 14q, 14r, ... that are punched out in the vicinity of the respective control board side through holes 14m, 14n, 14o, ... (the control board side through holes 14m, 14n, 14o,... and the confirmation holes 14p, 14q, 14r, ... are shown in enlargement in FIG. 9 (a))

Then, terminals 9a, 9b, 9c, ... of the connector 9 for connecting with the vehicle system are joined to the corresponding connector side through holes 14i, 14j, 14k, ... by soldering.

On the other hand, although in the first and second examples, the connecting board 14 and the control board 10 do not overlap in a vertical direction with respect to a plane in which the control board 10 is disposed (the vertical direction in FIG. 8 (b)), as shown in FIGS. 8 (a) and (b), the connecting board 14 of the third example partially overlaps the control board 10 in the vertical direction with respect to the control board 10 (the vertical direction in FIG. 8 (b)). Further, in this overlapping, the respective control board side through holes 14m, 14n, 14o, ... are positioned to coincide with terminals 10b₁, 10b₂, 10b₃, ... in the corresponding terminal group 10b on the control board 10, and are bonded so as to overlap as shown in FIG. 9 (b).

In this case, as shown in enlargement in FIG. 10 (a), the corresponding terminals 10b₁, 10b₂, 10b₃, ... are exposed in the respective confirmation holes 14p, 14q, 14r, ... That is, even if the connecting board 14 and the control board 10 are overlapped partially, the terminals 10b₁, 10b₂, 10b₃, ... can be recognized visually through the confirmation holes 14p, 14q, 14r, ...

Then, as shown in FIG. 9 (b), the control board side through holes 14m, 14n, 140_{,} ... and the terminals 10b₁, 10b₂, 10b₃, ... are joined by soldering through the control board side through holes 14m, 14n, 14o, .... At this point, if it is confirmed visually that solder is seeping out, as is the case with the confirmation holes 14p and 14q, as shown by way of example in FIG. 10 (b), then it can be verified that soldering has been achieved sufficiently to a rear face of the control board side through hole 14p. If it is confirmed visually that no solder is seeping out, as is the case with the confirmation holes 14q and 14r, it can be verified that soldering has not been achieved sufficiently to a rear face of the control board side through hole 14q. Further, it is possible to visually verify that adjacent soldering are not joined, that is, no soldering bridge has been generated.

In this way, the terminals 9a, 9b, 9c, ... of the connector 9 for connecting with the vehicle system, and the terminals 10b₁, 10b₂, 10b₃, ... of the control board 10 are connected electrically through a circuit pattern in the connecting board 14.

Other structures of the control apparatus with shift position detecting device 1 according to the third example are identical to the first and second examples.

Since, in the control apparatus with shift position detecting device 1 according to the third example, the terminals 9a, 9b, 9c, ... of the connector 9 for connecting with the vehicle system, the terminals 10b₁, 10b₂, 10b₃, ... of the control board 10 and the through holes 14i, 14j, 14k, ... and 14m, 14n, 14o, ... in the connecting board 14 are joined together by soldering using the connecting board 14 comprised of the flexible printed circuit board, a large bonding strength can be obtained, thereby increasing bonding performance.

Thus, it is not necessary to carry out the kind of strict quality control performed for wire bonding regarding prevention of contamination adhesion to the surface, prevention of oxidation of the surface, surface roughness, and the like with regards to surface conditions of the terminals 9a, 9b, 9c, ... of the connector 9 for connecting with the vehicle system, and the terminals 10b₁, 10b₂, 10b₃, ... of the control board 10. Consequently, labor needed for electrical connection operations for the terminals 9a, 9b, 9c, ... of the connector 9 for connecting with the vehicle, and the terminals 10b₁, 10b₂, 10b₃, ... of the control board 10 can be reduced and production cost can be reduced also.

In particular, even if the automatic transmission or the electronic control unit is placed in a severe environment caused by engine vibration in the engine room, vehicle body vibration during vehicle running or the like, electrical connection between the terminals 9a, 9b, 9c, ... of the connector 9 for connecting with the vehicle system and the terminals 10b₁, 10b₂, 10b₃, ... of the control board 10 can be made secure, thereby achieving further effective reductions in labor and production cost.

Further, since the confirmation holes 14p, 14q, 14r, ... can be used to check whether soldering has been achieved sufficiently, that is, whether or not soldering has been achieved well, bonding strength of the terminals 9a, 9b, 9c, ... of the connector 9 for connecting with the vehicle system and the terminals 10b₁, 10b₂, 10b₃, ... of the control board 10 with the through holes 14i, 14j, 14k, ... and 14m, 14n, 14o, ... can be definitely increased. Therefore, even if the electronic control unit is placed under the aforementioned severe environment, electrical connection between the terminals 9a, 9b, 9c, ... of the connector 9 for connecting with the vehicle system and the terminals 10b₁, 10b₂, 10b₃, ... of the control board 10 can be achieved securely.

Moreover, since solder enters the punched-out portion which forms the through hole, it is difficult for the solder to make a direct contact between adjacent bonding portions, thereby suppressing generation of the soldering bridge and preventing a short-circuit between the adjacent bonding portions.

Other operational effects of the control apparatus with shift position detecting device 1 according to the third example are identical to the first and second examples.

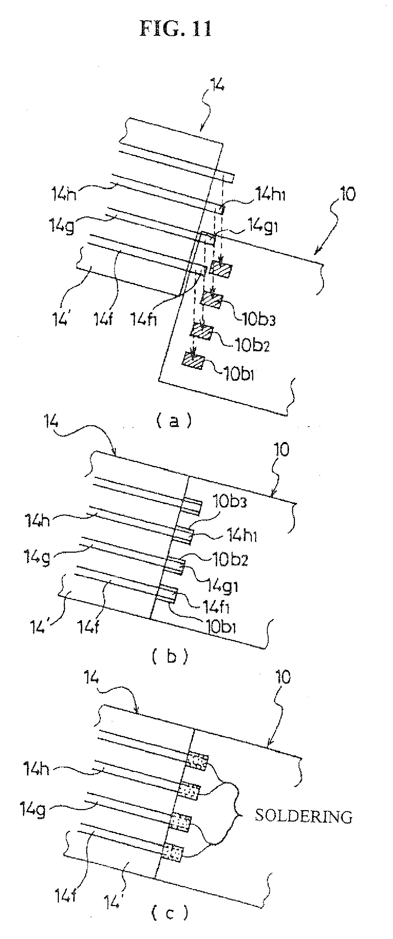

FIG. 11 shows schematically a portion of a fourth example of an embodiment of the present invention, where (a) is the same diagram as FIG. 9 (a) showing a state before the control board and the connecting board are bonded together, (b) is the same diagram as FIG. 9 (b) showing a state where the control board and the connecting board are bonded together and (c) is the same diagram as FIG. 10 (b) showing a state where soldering has been carried out.

Although in the aforementioned third example, a predetermined quantity of the control board side through holes 14m, 14n, 14o, ... are provided in the connecting board 14, and these control board side through holes 14m, 14n, 14o, ... and the terminals 10b₁, 10b₂, 10b₃, ... on the control board 10 are connected electrically, in the control apparatus with shift position detecting device 1 according to the fourth example as shown in FIG. 11, the conductors 14f, 14g, 14h, ... of the connecting board 14 are projected from an edge of the flexible board 14' and a predetermined quantity of terminals 14f₁, 14g₁, 14h₁, ... are formed on the projected portions (although four are shown in the example in the diagram, the number is not restricted to this, and the same quantity as the conductors on the connecting board 14 can be provided).

Further, as shown in FIG. 11 (a), the terminals 14f₁, 14g₁, 14h₁, ... of the connecting board 14 and the terminals 10b₁, 10b₂, 10b₃, ... of the corresponding control board 10 are matched with each other and then, as shown in FIG. 11 (b), the connecting board 14 and the control board 10 are bonded together. In addition, as shown in FIG. 11 (c), the terminals 14f₁, 14g₁, 14h₁, ... and the corresponding terminals 10b₁, 10b₂, 10b₃, ... of the control board 10 are joined together by soldering.

Other structures of the control apparatus with shift position detecting device 1 according to the fourth example are identical to the third example.

Since, in the control apparatus with shift position detecting device 1 according to the fourth example that is structured in such a way, the terminals 14f₁, 14g₁, 14h₁, ... can be formed more easily than the aforementioned through holes, cost can be reduced.

Further, since soldering is applied directly to the terminals and the terminals are brought into a face contact with each other, the bonding strength of each terminal can be made large.

Other operational effects of the control apparatus with shift position detecting device 1 according to the fourth example are identical to the third example.

Not that even on the connector side, terminals identical to the terminals 14f₁, 14g₁, 14h₁, ... can be joined to the terminals 9a, 9b, 9c,... of the connector 9 for connecting with the vehicle system instead of the through holes.

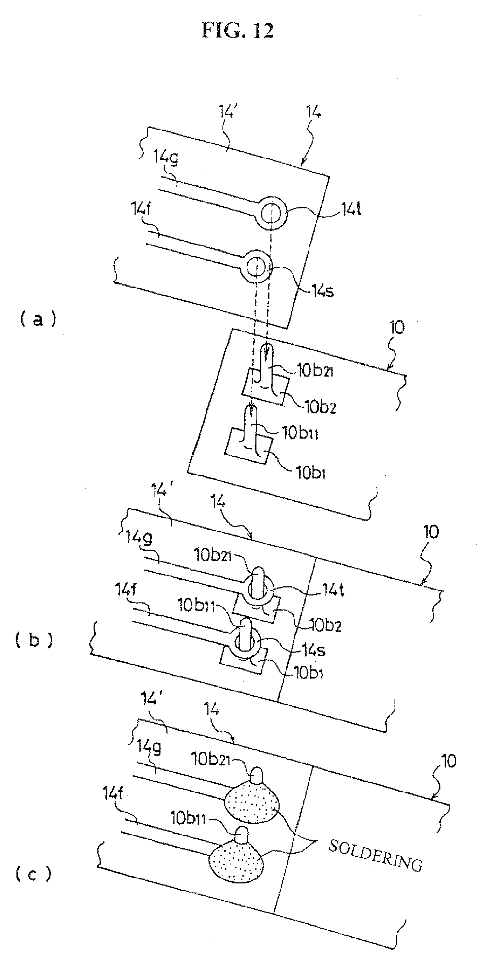

FIG. 12 shows schematically a portion of a fifth example of an embodiment of the present invention, where (a) is the same diagram as FIG. 11 (a) showing a state before the control board and the connecting board are bonded together, (b) is the same diagram as FIG. 11 (b) showing a state where the control board and the connecting board are bonded together, and (c) is the same diagram as FIG. 11 (c) showing a state that soldering has been carried out.

Although in the aforementioned third example, the connecting board 14 is provided with a predetermined quantity of the control board side through holes 14m, 14n, 14o, ... and these control board side through holes 14m, 14n, 14o, ... and the terminals 10b₁, 10b₂, 10b₃, ... of the control board 10 are joined together electrically, in the control apparatus with shift position detecting device 1 according to the fifth example as shown in FIG. 12, a predetermined quantity of lands 14s and 14t is provided instead of the control board side through holes 14m, 14n, 14o, ... (although two lands are shown in the example in the diagram, the number is not restricted to this and any number may be provided) and through holes (corresponding to the punched-out portion of the present invention) are formed in these lands 14s and 14t by punching out. Further, the terminals 10b₁, 10b₂ of the control board 10 are provided with a predetermined quantity of pins 10b₁₁ and 10b₂₁ (the same number as that of the lands 14s and 14t) which are provided so as to project.

Further, as shown in FIG. 12 (a), the lands 14s and 14t on the connecting board 14 are matched with the corresponding pins 10b₁₁ and 10b₂₁ on the control board 10 and, as shown in FIG. 12 (b), the corresponding pins 10b₁₁ and 10b₂₁ are inserted into through holes in the lands 14a and 14t, and then the connecting board 14 and the control board 10 are bonded together. In addition, as shown in FIG. 12 (c), the respective pins 10b₁₁ and 10b₂₁ on the control board 10 corresponding to the lands 14s and 14t are joined with the lands 14s and 14t by soldering.

Other structures of the control apparatus with shift position detecting device according to the fifth example are identical to the third example.

Since, in the control apparatus with shift position detecting device 1 according to the fifth example that is structured in such a way, the pins 10b₁₁ and 10b₂₁ are inserted into the through holes in the lands 14s and 14t, and soldered, the respective terminals 10b₁ and 10b₂, and the lands 14s and 14t can be joined with each other firmly.

Other operational effects of the ECU I of the fifth example are identical to the third example.

Note that only conductive through holes may be provided without provision of the lands 14s and 14t.

Furthermore, even on the connector side, the connecting board 14 may be provided with lands identical to the lands 14s and 14t described above, the connector may be provided with pins identical to the pins 10b₁₁ and 10b₂₁ and then these may be joined together in the same way as described above.

Furthermore, the fifth example may also be provided with identical confirmation holes to the confirmation holes 14p, 14q, ... of the third example.

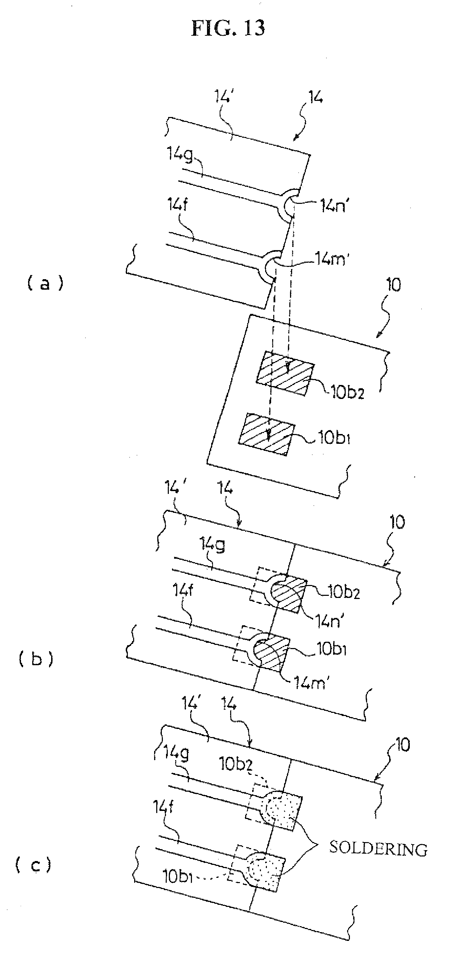

FIG. 13 shows schematically a portion of a sixth example of an embodiment of the present invention, where (a) is the same diagram as FIG. 11 (a) showing a state before the control board and the connecting board are bonded together, (b) is the same diagram as FIG. 11 (b) showing a state where the control board and the connecting board are bonded together, and (c) is the same diagram as FIG, 11 (c) showing a state where soldering has been carried out.

Although in the aforementioned third example, the predetermined quantity of the control board side through holes 14m, 14n, 14o, ... are provided in the connecting board 14 each having a whole circumference, in the control apparatus with shift position detecting device 1 according to the sixth example shown in FIG. 13, the control board side through holes 14m and 14n are cut in half into semicircular shapes (although the two control board side through holes 14m and 14n are shown in the example in the diagram, the number is not restricted to this and any number may be provided). That is, conductive, semi-circular concave portions 14m' and 14n' are formed at an edge of the connecting board 14. Note that the concave portions 14m' and 14n' are not restricted to a semi-circular shape, but may be formed by cutting out a portion of a through hole formed with any predetermined sectional shape.

In addition, as shown in FIG. 13 (a), the positions of the terminals 10b₁ and 10b₂ on the control board 10 corresponding to the concave portions 14m' and 14n' in the connecting board 14 are aligned and, as shown in FIG. 13 (b), the connecting board 14 is bonded with the control board 10. Further, as shown in FIG. 13 (c), the terminals 10b₁ and 10b₂ on the control board 10 corresponding to the concave portions 14m' and 14n' are joined together by soldering.

Other structures of the ECU 1 of the sixth example are identical to the third example.

Since, in the control apparatus with shift position detecting device 1 according to the sixth example that is structured in such a way, by soldering the respective concave portions 14m' and 14n' with the terminals 10b₁ and 10b₂, the solder in the respective concave portions 14m' and 14n' becomes formed together, the concave portions 14m' and 14n' with the terminals 10b₁ and 10b₂ can be joined with each other firmly.

Further, since the respective concave portions 14m'and 14n' are formed by cutting through holes in half, the concave portions 14m' and 14n' can be formed easily.

Other operational effects of the ECU 1 of the sixth example are identical to the third example.

Note that even on the connector side, the connecting board 14 may also be provided with concave portions identical to the concave portions 14m' and 14n' described above, and these may be joined together in the same way as described above.

Further, this sixth example may also be provided with confirmation holes identical to the confirmation holes 14p, 14q, ... of the third example.

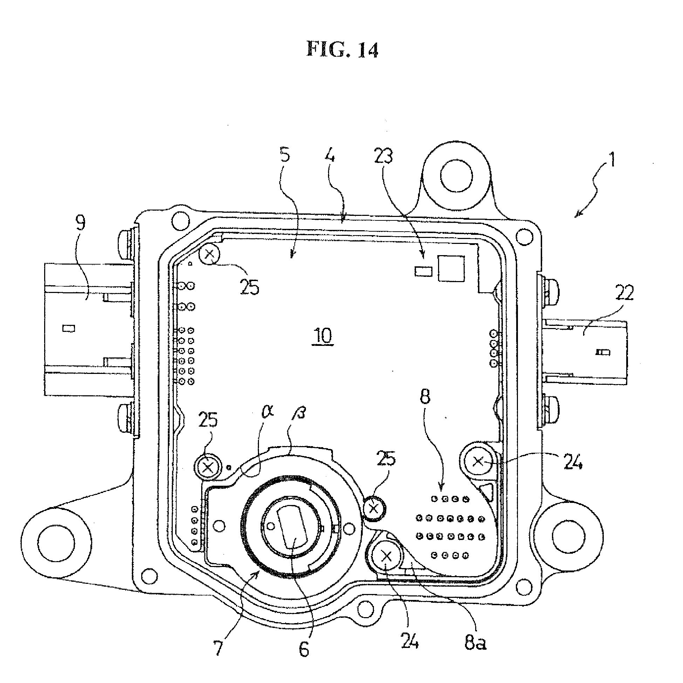

FIG. 14 is a plan view showing a seventh example of an embodiment of the control apparatus with shift position detecting device according to the present invention.

Although in the first embodiment described above, the connecting board 14 is disposed between the control board 10 and the shift position detecting device 7, the control apparatus with shift position detecting device 1 according to the seventh example as shown in FIG. 14 omits the connecting board 14, and the control board 10 is extended over a portion where the connecting board 14 according to the first example is provided. This control board 10 is formed of, for example, easy to process material such as glass cloth epoxy board having a high heat dissipation capacity and a high heat resistance. A portion α of the shape of the control board 10 conforms to a portion β of the outer shape of the shift position detecting device 7, so that the control board 10 occupies substantially entire face except the portion in which the shift position detecting device 7 is disposed within the casing 4. In this way, the interior of the casing 4 is employed effectively without dead space in the same was as the first example.

The seventh example can reduce costs to below that for the ceramic board or the like by, in particular, using a glass cloth epoxy board having a high heat dissipation capacity and heat resistance.

Further, cost reduction can be achieved because emitting the connecting board 14 can reduce the quantity of components.

Other structures and operational effects of the seventh example are identical to the first example.

Note that, although in the first and second examples, the shift position detecting device 7, the ECU 5 and the connector portions (the connector 8 for connecting with the A/T and the connector 9 for connecting with the vehicle system) are integrated, the present invention is not necessarily restricted to this, but may be applied to the control apparatus with shift position detecting device 1 in which at least the shift position detecting device 7 and the ECU 5 control unit are integrated.

Further, although in the first and second examples, the connecting board 14 is formed to conform to both the shape of the control board 10 and the sectional shape of the shift position detecting device 7, the present invention allows the shape of the connecting board 14 to be formed so it conforms to any one of these shapes.

In this case, the connecting board 14 may be formed into a shape conforming with the quantity of terminals on the output circuit portion 7a of the shift position detecting device 7.

Further, although in the second example, the connecting board which connects the shift position detecting device 7 to the control board 10, and the connecting board which connects the connector 8 for connecting with the A/T to the control board 10 are constructed of a single common connecting board 14d, these connecting boards can be provided separately. In simple terms, the connecting board which connects the shift position detecting device 7 to the control board 10, the connecting board which connects the connector 8 for connecting with the A/T to the control board 10, and the connecting board which connects the connector 9 for connecting with the vehicle system to the control board 10 may all be provided separately, or of these connecting boards, at least two connecting boards may be formed from a common single board. In this way, by forming two connecting boards on a common single board so as to commonize a connecting board, not only the quantity of the connecting boards can be reduced, but also, when for example a connecting board is fixed to the casing 4, the quantity of bolts can be reduced, thereby achieving reduction in cost.

Further, conversely to this example, the connecting boards may be constructed in a split fashion in order to suppress a yield rate of the connecting boards.

Moreover, although in the first example, the shift position detecting device 7 is formed with a circular section, in the present invention, the output circuit portion 7a may have a projection portion (not shown), which is included in the sectional shape of the shift position detecting device, forming its section into an elliptical shape or a substantially elliptical shape composed of the major axis and the minor axis. In this case, the major axis and the long side of the control board 10 may be arranged so as to be parallel or substantially parallel. Since in this case, the major axis of the sectional shape of the shift position detecting device 7 containing the projection portion and the long side of the control board 10 are parallel or substantially parallel, the shift position detecting device 7 and the ECU 5 can be disposed effectively in terms of space, thereby enabling the control apparatus with shift position detecting device 1 to be formed more effectively in a compact configuration.

Moreover, the electrical connecting means is not restricted to the aforementioned soldering, but other appropriate electrical connecting means may be used. However, soldering is preferred because it can be carried out easily and securely.

Moreover, the connecting board 14 is not restricted to a flexible printed circuit board, but may use any board having a conductive circuit pattern, for example, the aforementioned glass epoxy board or the like.

Moreover, although according to the third to sixth examples, the connecting board 14 overlaps the control board 10 in a vertical direction with respect to the plane in which the control board is disposed on substantially the same plane, the output circuit portions 7a and 19a of the shift position detecting device 7, and the connecting board 14 may be disposed to overlap each other in a vertical direction on substantially the same plane according to the same method as in the third to sixth examples. Consequently, the same operational effects can also be obtained in the output circuit portions 7a and 19a, and the connecting board 14.

Although the present invention is applied to an A/T in the aforementioned respective examples, the control apparatus with shift position detecting device 1 according to the present invention may be applied to the other aforementioned power trains.

Moreover, the shift position detecting device 7 for detecting a change due to an operation of the vehicle driver is not restricted to detection of a shift, position from rotational movement of a movable object such as a rotor, but the present invention may be applied to detection of a shift position from linear motion of a slider or the like.

### INDUSTRIAL APPLICABILITY

The present invention provides a control apparatus with shift position detecting device, wherein at least one of a shift position detecting device, an electronic control unit and a connector portion may be laid out freely, or a board of the control unit may correspond easily and flexibly to the shape of the shift position detecting device or easily and flexibly to at least one of the shapes of the shift position detecting device, the control unit and the connector portion. Consequently, the control apparatus with shift position detecting device according to the present invention is capable of corresponding easily and flexibly with a power train with which it is to be mounted.

## Claims

1. A control apparatus with shift position detecting device, in which a shift position detecting device (7) for detecting a shift position that changes in accordance with an operation of a vehicle driver and a control unit (5) having a control board (10) that includes a plurality of devices for controlling a power train based on a detection signal of at least a vehicle running state are accommodated in a casing (4), **characterized in that** the shift position detecting device (7) and the control board (10) are electrically connected, wherein the control board (10) conforms to the shift position detecting device (7) and both together conform to the inner circumference of the casing (4), and wherein a portion (α) of the shape of the control board (10) conforms to a portion (β) of the outer shape of the shift position detecting device (7) so that the control board (10) occupies substantially the entire face except the portion in which the shift position detecting device (7) is disposed within the casing (4).

2. The control apparatus according to claim 1, wherein the control board (10) is formed of an easy to process material.

3. The control apparatus according to claim 1 or 2, wherein the control board (10) is constituted by a glass cloth epoxy board having a high heat dissipation capacity and a high heat resistance.

4. The control apparatus according to claim 1, 2, or 3, wherein the shift position detecting device (7) has a circular section orthogonal to its axial direction, and the control board (10) is formed with an external shape having a curvature that conforms to the circular section.

5. The control apparatus according to any one of claims 1 to 4, wherein the shift position detecting device (7) or the control board (10) is connected electrically by a connecting board (14) that is easy to process.

6. The control apparatus according to claim 5, wherein the connecting board (14) conforms to the shape of the shift position detecting device (7) or the shape of the control unit (5).

7. The control apparatus according to claim 5 or 6, wherein the connecting board (14) is constituted of material that is easier to process than the control board (10).

8. The control apparatus according to any one of claims 5 to 7, wherein the control board (10) and the shift position detecting device (7) are connected through the connecting board (14).

9. The control apparatus according to any one of claims 5 to 8, comprising a connector portion which is integrated with the shift position detecting device (7) and the control unit (5), and connected to an electrical unit located outside the casing (4), wherein the connector portion is connected to the control board (10) through the connecting board (14).

10. The control apparatus according to claim 9, wherein the connector portion includes a first connector portion that connects to an electrical unit within the power train and a second connector portion that connects to a vehicle system outside the power train.

11. The control apparatus with shift position detecting device according to claim 10, wherein the control board (10) is formed in a quadrangular shape, and the connecting board (14) is formed in a shape that conforms to the quadrangular shape of the control board.

12. The control apparatus according to any one of claims 9 to 11, wherein the connector portion has a stress absorbing and alleviating portion.

13. A power train **characterized by** including the control apparatus with shift position detecting device according to any one of claims 1 to 12.
